Europäisches Patentamt

European Patent Office

Office européen des brevets

(19)

(11) **EP 1 417 681 B1**

(12) **EUROPEAN PATENT SPECIFICATION**

(45) Date of publication and mention
of the grant of the patent:
**08.12.2004 Bulletin 2004/50**

(51) Int Cl.⁷: **G11B 7/24**, G11B 7/00,
G11C 13/04, G11B 7/26

(21) Application number: **01965170.2**

(22) Date of filing: **20.07.2001**

(86) International application number:
**PCT/EP2001/009025**

(87) International publication number:
**WO 2003/010762 (06.02.2003 Gazette 2003/06)**

(54) **PHOTONICS DATA STORAGE SYSTEM USING A POLYPEPTIDE MATERIAL AND METHOD FOR MAKING SAME**

PHOTONISCHES DATENAUFZEICHNUNGSSYSTEM UNTER VERWENDUNG VON POLYPEPTIDMATERIAL, UND VERFAHREN ZUR DESSEN HERSTELLUNG

SYSTEME DE STOCKAGE DE DONNEES PHOTONIQUES METTANT EN OEUVRE UN MATERIAU POLYPEPTIDIQUE ET PROCEDE DE FABRICATION DE CELUI-CI

(84) Designated Contracting States:
**AT BE CH CY DE DK ES FI FR GB GR IE IT LI LU MC NL PT SE TR**

(43) Date of publication of application:
**12.05.2004 Bulletin 2004/20**

(73) Proprietor: **Research Investment Network, Inc Irvine, CA 92614 (US)**

(72) Inventors:
• **EL-HAFIDI, Idriss**
**67100 Strasbourg (DE)**
• **GRZYMALA, Romualda**
**67000 Strasbourg (FR)**
• **MEYRUEIS, Patrick**
**67000 Strasbourg (FR)**
• **KIEFER, Renaud**
**67800 Hoenheim (FR)**
• **TAKAKURA, Yoshitate**
**67400 Illkirch (FR)**

(74) Representative: **Cabinet Hirsch**
**58, avenue Marceau**
**75008 Paris (FR)**

(56) References cited:
EP-A- 0 476 536          WO-A-00/30084
WO-A-96/38410          US-A- 2 624 672

• **MANSURIPUR M ET AL: "PRINCIPLES AND TECHNIQUES OF OPTICAL DATA STORAGE" PROCEEDINGS OF THE IEEE, IEEE. NEW YORK, US, vol. 85, no. 11, 1 November 1997 (1997-11-01), pages 1780-1796, XP000755848 ISSN: 0018-9219**

**Description**

**FIELD OF INVENTION**

The present invention generally relates to a photonics data memory. In particular, the present invention relates to a storage material for use in the photonics data memory and a process for making said storage material. And in particular, the present invention relates to apparatuses for recording/reading information to/from the photonics data memory. WO-A-0 030 084 disclolses a photonics memory as indicated in the preamble of claim 1.

**BACKGROUND OF THE INVENTION**

The large storage capacities and relative low costs of CD-ROMS and DVDs have created an even greater demand for still larger and cheaper optical storage media. Holographic memories have been proposed to supersede the optical disc as a high-capacity digital storage medium. The high density and speed of the holographic memory comes from three-dimensional recording and from the simultaneous readout of an entire packet of data at one time. The principal advantages of holographic memory are a higher information density ($10^{11}$ bits or more), a short random access time ( ~ 100 microseconds and less), and a high information transmission rate ($10^9$ bit/sec).

In holographic recording, a light beam from a coherent monochromatic source (e.g., a laser) is split into a reference beam and an object beam. The object beam is passed through a spatial light modulator (SLM) and then into a storage medium. The SLM forms a matrix of shutters that represents a packet of binary data. The object beam passes through the SLM which acts to modulate the object beam with the binary information being displayed on the SLM. The modulated object beam is then directed to one point on the storage medium by an addressing mechanism where it intersects with the reference beam to create a hologram representing the packet of data.

An optical system consisting of lenses and mirrors is used to precisely direct the optical beam encoded with the packet of data to the particular addressed area of the storage medium. Optimum use of the capacity of a thick storage medium is realized by spatial and angular multiplexing. In spatial multiplexing, a set of packets is stored in the storage medium shaped into a plane as an array of spatially separated and regularly arranged subholograms by varying the beam direction in the x-axis and y-axis of the plane. Each subhologram is formed at a point in the storage medium with the rectangular coordinates representing the respective packet address as recorded in the storage medium. In angular multiplexing, recording is carried out by keeping the x- and y- coordinates the same while changing the irradiation angle of the reference beam in the storage medium. By repeatedly incrementing the irradiation angle, a plurality of packets of information is recorded as a set of subholograms at the same x- and y-spatial location.

A volume (thick) hologram requires a thick storage medium, typically a three-dimensional body made up of a material sensitive to a spatial distribution of light energy produced by interference of a coherent light beam and reference light beam. A hologram may be recorded in a medium as a variation of absorption or phase or both. The storage material must respond to incident light patterns causing a change in its optical properties. In a volume hologram, a large number of packets of data can be superimposed, so that every packet of data can be reconstructed without distortion. A volume (thick) hologram may be regarded as a superposition of three dimensional gratings recorded in the depth of the emulsion each satisfying the Bragg law (i.e., a volume phase grating). The grating planes in a volume hologram produce change in refraction and/or absorption.

Several materials have been considered as storage material for optical storage systems because of inherent advantages. These advantages include a self-developing capability, dry processing, good stability, thick emulsion, high sensitivity, and nonvolatile storage. These materials also have demonstrated disadvantages which will be discussed below.

Photorefractive crystals such as those formed, for example, by lithium niobate ($LiNbO_3$) have been used for recording volume phase holograms in real-time. Data in the form of holograms have been successfully stored in these crystals. The storage mechanism consisting in redistributing the photoelectrons in the crystal when variations in the intensity of the laser beam cause the modifications in the local refractive index at each point in the crystal. The photorefractive materials contain localized centers with trapped electrons that can be excited into the conduction band by the action of light. When this material is exposed to an interference pattern, the electric charges from interference maxima drift and/or diffuse and are (trapped) collected at the interference minima. The space charge pattern creates a strong spatially periodic field. This field deforms the crystal by the Pockels effect and causes a refractive index modulation producing a hologram.

However, these photorefractive crystals have a number of drawbacks. First, there is a very low tolerance in terms of localizing the read beam. This is because, given the crystalline nature of the solid employed, the addressing of the desired data tolerates an angular deviation with respect to the angular value in question of only about a few milliradians, requiring in fact the use of a read device of very high precision, resulting in a prohibitively large increase in the fabrication cost. This low tolerance also comes up against a technological availability problem. At the present time no system is capable of combining, simultaneously, precise angular control with rapid angular control. Either such a system is precise but not rapid, or it is rapid but not precise. Moreover, the energy needed to record data in such a material is of the order of 1 watt/cm$^2$ In addition, recording a packet in the conventional format requires an area of about 1 cm$^2$ which, moreover, has to be doubled with a depth of the material of at least 1 cm, therefore resulting in a medium of relatively large dimensions. Moreover and above all, these materials have an unacceptable defect, namely that reading the data stored in the material results in erasure of the data, something which, as is readily appreciated, is in complete conflict with the desired objective of serving as a storage medium. In order to overcome this major problem, a novel, nondestructive, method of reading has in fact been proposed, which makes use both of an electric field and a beam of polarized light. In this way, the holograms require more energy to erase the data than to store the data. However, this technique requires an apparatus which is more complicated to employ and is also not conducive to rapid access to the information stored. Recent progress made in the field of photorefractive systems has not adequately solved these basic problems. Physical limitations of a theoretical nature remain, so that it is not conceivable to overcome these problems in the near future. Finally, the difficulties encountered in growing the crystals preclude any reproducibility with economically viable scale-up costs.

Photopolymer materials are also capable of forming memories based on optical diffraction. The technology employed relies on the polymerization of photosensitive monomers under the action of a laser beam carrying the hologram to be stored. The concentration gradient of the photosensitive species which results from the polymerized pattern causes the unpolymerized photosensitive species to diffuse and generates a pattern which converts the original optical interference into a modulation of the refractive index. Analyzing this index modulation by means of a suitable read beam allows the information stored to be retrieved.

While it is true that these materials allow relatively large amounts of data to be stored, they have the drawback of being quite unstable over time. This instability can vary depending on their exposure to light, and especially to UV radiation. Even in the absence of light, the stored data is liable to disappear. Physicochemical processes have been developed in order to increase the stability of the stored information. But these prove to be not very satisfactory in so far as in all cases they significant increase the noise, to above the permissible levels.

Moreover, the photopolymers introduce a reduction in the thickness of the material of about 7 to 10%, resulting in a change in the Bragg angle when retrieving or reading. This change must be compensated for either by modifying the geometry of the read system or by modifying the wavelength of the read beam. This notion of Bragg angle results from the multiplexing, that is to say from the storage of several holograms in the same volume. To do this, the angle of incidence of the reference laser beam is modified during the phase of storing the information within the medium. This reference laser beam interferes coherently with the laser beam carrying the information to be stored, and conventionally called the object beam, so as to form the interference pattern or hologram, which will be stored in the medium due to the perturbation in the refractive index. Thus, each hologram is stored at a unique angle of the reference beam. The separation between the various holograms stored within the same volume relies on the coherent nature of the hologram, in order to allow its retrieval in phase within the said volume only for a defined angle value. Retrieving the stored information therefore requires the use of a read beam whose characteristics correspond to those employed for writing or for storage (wavelength, angle of incidence and position within the storage material). This read beam induces diffraction due to perturbation in the refractive index corresponding to the characteristics of the beam, thereby creating the stored modulated beam. Thus, the great importance of the variation in the Bragg angle for correctly and rapidly retrieving the stored information is recognized.

Also developed, in parallel with the above two technologies, has been the technology called PHB (Photochemical Holes Burning). This technology relies on the use of quantum effects. More precisely, this technology consists in creating a novel absorption profile for a material exposed to the action of a light source. This excitation is different depending on the species present in the material, which have different absorption lines from that of the main channel. If this burning is of sufficient duration, the burning of the holes is said to be persistent. Materials having this characteristic are amorphous solids (polymers, inorganic glasses, xerogels) doped with organic molecules. Ion-doped crystals may also develop these characteristics.

The "hole burning" effect is generated in principle when the material is cooled. This phenomenon is accentuated at temperatures equal to or below that of liquid helium (4.2 K). In this case, the homogeneous absorption line is very narrow and the disorder of the amorphous medium gives absorption lines dispersed over a wide band, called the inhomogeneous absorption band. The medium thus behaves as a photosensitive medium whose spectral sensitivity depends on the wavelength of the inhomogeneous absorption band. The material can then record data: it can be used for spectral hole burning holography. The light source used is a dye laser for recording at several wavelengths in a doped amorphous material. During the recording operation, the material is placed under a high voltage in a cryostat. The inherent difficulty with this technology for multiplexed data storage resides in the need to maintain a low temperature throughout the recording operation. Another difficulty is how to control the wavelengths of the dye laser very accurately. Consequently, this type of technology is not conceivable in the immediate future for storage of diffractive memories.

Thus, the materials discussed above have disadvantages when used as a holographic storage media. In addition to avoiding the above disadvantages, it is desirable to develop a storage material which has a high diffraction efficiency and a low cross-talk

Diffraction efficiency is a storage medium parameter meaning the ratio of the light of the read beam used for data packet reconstruction to the total light of the read beam incident on the hologram. Thus, a material with a high diffraction efficiency will use less power for each read operation which retrieves a packet.

Crosstalk occurs during retrieval of the stored data, resulting in the desired data and neighboring data being retrieved simultaneously. The interfering patterns from the neighboring data significantly affects the quality of the information sought. This crosstalk problem depends directly on the angular bandwidth of each hologram, that is to say on the mid-height width of the maximum diffraction efficiency as a function of the angle of incidence, and also defined as being the angular band within which the angle of the incident reference beam can vary without reducing the quality of the information contained in a packet read out.

Once an adequate storage material is found for the storage of holographic information, the material is shaped into a storage medium (e.g. square matrix, cube, disc) and corresponding apparatuses subsequently developed for recording information onto and reading information from the material. The apparatuses are designed to take advantages of the properties of the material. For example, a storage material may permit faster access of information or require less precision in the positioning of the beam which still maintaining crosstalk within an expectable tolerance. A control mechanism typically under computer control drives the optical beams during both the record phase and the write phase to rapidly focus the optical beams accurately at a specific point location and angle with respect to the storage medium. It presents a significant challenge to a designer of a holographic storage system to design a mechanism for accurately positioning of the beam within the required tolerances, especially of the angle of the beam.

## OBJECTS OF THE INVENTION

In view of the foregoing, it is an object of the present invention to provide a photonics data storage system using a material making it possible both to considerably increase the memory capacity and, in parallel, to optimize the address speed, that is to say to limit the time for access to the stored information sought.

It is another objective of the present invention to develop a polypeptide material for the recording and storage of information by interferometric coding with a reference laser beam.

It is another objective of the present invention to develop a polypeptide material in which information is capable of being stored by an interference pattern using spatial and angular multiplexing.

It is another object of the present invention to develop a polypeptide material having minimum crosstalk in which information is capable of being stored by an interference pattern via angular multiplexing.

It is another object of the present invention to develop a polypeptide material in which information is capable of being stored by an interference pattern via angular multiplexing with a high diffraction efficiency.

It is a further object of the present invention to provide software for accurately positioning the angle of the read beam in a polypeptide material.

It is still another object of the present invention to provide a photonics data storage system with transformational nodes within an optical path to direct the read beam onto the storage medium within a precision which takes into consideration the nature of the storage material.

The objects and advantages will become apparent from the following disclosure.

## SUMMARY OF THE INVENTION

In order to achieve the above-mentioned objectives, there is a photonics memory as indicated in claim 1. Data is encoded in the storage medium by an interferometric process. The recording medium is made up of a polypeptide material based on or derived from a collagen, such as pork skin collagen, chicken leg (bone) collagen, and the like, The polypeptide material comprises a gel of chromium-doped collagen based polypeptide, in which alpha and beta chains are predominately present in portions such that the alpha/beta chains weight ration is greater than 1.

In a further aspect of the present invention, the alpha/beta chains weight ration is between about 1.2 and about 2.1.

In yet another aspect of the present invention, the chromium doping is carried out by adding a chromium VI salt in an aqueous solution to the polypeptide solution in an amount of about 5 to about 10% by weight of dry polypeptide, preferably about 10%. A 5% addition of chromium VI salt gives a chromium loading of about 100 mg per 100 ml of polypeptide solution (5% polypeptide).

In still a further aspect of the present invention, the average molecular weight of the polypeptide starting material is between about 120,000 and about 150,000 Daltons, preferably about 120,000 Daltons.

According to another aspect of the present invention, the viscosity of the polypeptide gel is between about three and about four centipoise, preferably about 3.5 centipoise, under Standard Conditions.

In still further aspect of the present invention, the polypeptide can be doped or treated with a hardening (tanning, curing) agent. Hardening is preferred.

In still a further aspect of the present invention, the hardening agent comprises a water-soluble chromium III salt, if hardened before exposure, or alum if hardened during development.

In accordance with another aspect of the present invention, the collagen based polypeptide, or polypeptide derived from collagen, is doped or treated with a surfactant, such as a fluorinated surfactant or fluorocarbon surfactant.

In still another aspect of the present invention, a polypeptide material is produced for the purpose of making a storage medium. A polypeptide, normally in dry powder form, of biological origin, such as collagen, is solvated in water, preferably deionized water, for a period of about two to about ten hours at room temperature to form at least a partial polypeptide solution. During the solvation, the polypeptide swells. The solution is then heated to between about 40 and about 60 degrees Celsius until the polypeptide is completely dissolved. The polypeptide solution is then doped with Cr VI (a chromium +6 salt), and optionally with a surfactant and/or hardening agent. Thereafter the solution is maintained at a temperature between about 55 and about 60 degrees Celsius for a period of about 15 to about 60 minutes. The solution is then filtered. The solution thus obtained can be stored for future use or deposited as a coating or layer on a glass or plastic substrate. When stored for future use, the solution is stored under refrigerated conditions in the dark. The solution thus deposited is then chilled and dried to yield a polypeptide gel storage medium. The above steps, commencing with doping with Cr VI are carried out in the dark - red inactinic light can be used. The completed storage medium are stored at cold temperatures, around zero degrees Celsius, in the dark, to maintain their photosensitivity.

In yet another aspect of the present invention, prior to depositing the solution on the substrate, the substrate can be, and preferably is, provided with a thin hydrophilic adhesive layer to give better bonding between the polypeptide gel and the substrate. The adhesive layer is sandwiched between the substrate and the polypeptide gel layer.

In accordance with another aspect of the present invention, the polypeptide solution is deposited on the glass or plastic substrate. Glass substrates can be coated by gravitational coating. Plastic substrates are preferably plated by extrusion coating or the Doctor blade method. Film substrates can be plated with the Meyer bar coating method or roll dipping.

In still another aspect of the present invention, the polypeptide solution is molded between two sheets, such as glass and/or plastic sheets. One of the sheets can be metal, ceramic or stone, having a planar, smooth polished surface. The polypeptide solution is spread between the sheets and an internal surface, i.e. facing surface, of one the sheets is pretreated with a hydrophobic film or coating to prevent the polypeptide solution from adhering to the treated planar, smooth polished surface. The polypeptide solution adheres to the other sheet, a clear, transparent sheet. The final thickness of the storage or recording medium is defined by the spacing between the sheets which can be controlled by shims placed between the two sheets.

In still a further aspect of the present invention, the exposed recording medium is developed, i.e. fixed or fixed/hardened, dehydrated and dried. A transparent plate or sheet is glued to the top surface of the developed recording medium to protect the recorded medium from moisture and abrasion. Alternatively, the top or exposed surface of the developed recording medium can be protected with a layer or coating of varnish. Preferably the protective plate or varnish has a refractive index close to that of polypeptide. The varnish must bind to the exposed surface of the doped polypeptide and must be inert so as not to react with the polypeptide layer. In addition, the protective plate or varnish must be optically transparent to the wavelength of light used when reading the exposed, recorded recording medium. The varnish can be coated or deposited as a monolayer or can be applied as a multilayer as long as it does not disturb the optical signal during reading. Preferably the varnish is hydrophobic, not hydrophilic, and is not water-soluble.

The exposed recording medium is developed in a fixer solution at a temperature of between about 20 and about 22 degrees Celsius. Optionally the exposed recording medium can be hardened before the development. Preferably, if hardening has not been carried out before, the fixing and hardening are carried out together. We have found that a combination treatment with Kodak brand fixer and Kodak brand hardener yields reproducible results and excellent recorded medium. The exposed recording medium is placed in a solution of fixer, or of fixer and hardener, for about 4 to about 10 minutes. The recording medium turns color from orange brown to a colorless or very light green colored plate during development. The hardening step is important because the hardening operation can make the developed plate physically more stable from the influences of humidity and temperature.

Normally, the polypeptide only has to be hardened once, either following doping with Cr VI or just prior to or with fixing. Preferably the polypeptide is hardened during the fixing step.

The treated plate, fixed and optionally hardened is washed in a water bath[s] and dehydrated with a water miscible inert low boiling point organic solvent, such as methanol, ethanol, isopropanol, acetone, or the like. Preferably the dehydration is carried out incrementally using drier and drier solvent, such as with four sequential aqueous baths of 25% alcohol, 50% alcohol, 75% alcohol, and finally 100% alcohol. The dehydration is preferably done with agitation. The dehydration only a takes a few minutes in each alcohol bath with agitation. After dehydration, the exposed, hardened, fixed, washed recording medium, i.e. the recorded medium, is dried at an elevated temperature to remove the organic solvent to yield the polypeptide gel recording medium mounted on a substrate, such as a plate, sheet or film. The drying step can be carried out in a vacuum.

In another aspect of the present invention, digital information is stored in a storage medium, alternately referred to as a storage medium, made up of a polypeptide material. A reference light beam and an object light beam intersect in the polypeptide material forming an interference pattern which is stored throughout the entire thickness of the storage medium. The storage medium forms a volume phase grating in which the interference pattern is formed.

In a further aspect of the present invention, the polypeptide material is in the form of a flat sheet defined by rectangular co-ordinates (X,Y). A packet of digital information modulated onto the object light beam is encoded as a subhologram at a point of a plane of the flat sheet.

In yet another aspect of the present invention, the variation of the angular direction of the reference light beam is accomplished by variable spacing of from one to four degrees.

In still another aspect of the present invention, the storage medium is shaped in the form of a flat sheet defined by rectangular coordinates (X,Y) of a plane of the flat sheet. At least fifteen discrete variations are made in an angular direction of the reference light beam for coding a wavefront of the object light beam.

According to another aspect of the present invention, there is a system having a storage medium made up of a polypeptide material having stored therein digital information as a plurality of packets stored throughout the entire thickness of the storage medium. A read light beam is configured to address at least one of the packets in the storage medium.

In yet another aspect of the present invention. The read beam is directed and shaped by one or more transformation nodes located in an optical path of the read beam to one of a plurality of points defining a matrix on the storage medium as determined by one or more initial storage conditions and one or more operating parameters.

In still another aspect of the present invention, the initial storage conditions include the size of the matrix, the number of points of the matrix, and the physical characteristics of the polypeptide material. The physical characteristics of the polypeptide material include a selection of constitutive molecules and results from a process for preparing the polypeptide material. The process for preparing the polypeptide material determines a wavelength sensitivity of the polypeptide material and includes a coating method. The physical characteristics of the polypeptide material are determinable by a recording process. The recording process is defined by at least one of the following parameters: wavelength, temperature, humidity, and the physical characteristics of a substrate of the polypeptide material. The physical characteristics of the polypeptide material further include a post exposure process. The post exposure process is defined by factors such as the physical characteristic of baths and physical parameters such as temperature and humidity.

In yet another aspect of the present invention, the operating parameters includes the desired time needed to access the storage medium, the type of activators used, the level of miniaturization, and the level of resolution.

In a further aspect of the present invention, the nodes consist of dynamic devices. The dynamic devices are selected from a group comprising mirrors, micro mirrors associated with a rotating component, acoustooptic components, diffraction gratings associated with liquid crystals, Kerr cells and Pockels cells. The positioning in space of the dynamic devices and the control of their orientation are managed by software.

In yet another aspect of the present invention, components are positioned at the nodes for deflecting the read beam. The components comprise two acoustooptic devices which diffract, in a known manner, the read beam in an angular direction according to the frequency of ultrasonic waves applied. The components further comprise a diffraction grating located downstream with respect to the acoustooptic devices and oriented in such a way that a beam emerging from the acoustooptic devices strikes the active face of the grating at a first angle being optimized so that a diffracted beam emerges at a second grazing angle. The components further comprise at least one dynamic angular deflection device located downstream with respect to the grating directing the beam emerging from the grating onto the storage medium.

Further objects, advantages, and novel features of the present invention will become apparent to those skilled in the art from this disclosure, including the following detailed description, as well as by practice of the invention. While the invention is described below with reference to a preferred embodiment (s), it should be understood that the invention is not limited thereto. Those of ordinary skill in the art having access to the teachings herein will recognize additional implementations, modifications, and embodiments, as well as other fields of use, which are within the scope of the invention as disclosed and claimed herein and with respect to which the invention could be of significant utility.

## BRIEF DESCRIPTION OF THE DRAWINGS

In order to facilitate a fuller understanding of the present invention, reference is now made to the appended drawings. These drawings should not be construed as limiting the present invention, but are intended to be exemplary only.

FIG. 1 is a schematic representation of an apparatus for recording an interference pattern according to the present invention.

FIG. 2 is a schematic representation of a matrix of points formed in a storage medium.

FIG. 3 is a flow diagram of an algorithm used to record data packets onto the storage medium.

FIG. 4 is a block diagrams representative of the write phase according to the present invention.

FIG. 5A is a schematic representation of a node addressing design according to the present invention.

FIG. 5B shows an apparatus for controlling the position of the laser beam according to the present invention.

FIG. 6A is a schematic representation of an apparatus for reading packets of information in a storage medium according to the present invention.

FIG. 6B is a perspective view of the apparatus for reading a line of the matrix of the storage medium.

FIG. 6C shows the apparatus for reading a line configured to read the first line of the matrix.

FIG. 6D shows the apparatus for reading a line configured to read the last line of the matrix.

FIG. 6E shows the geometric relationship among the optical elements of the apparatus for reading a line of the matrix according to the present invention.

FIG. 6F shows an example of angle combinations of two mirrors for reading one packet located at point 1.

FIG. 6G shows an example of angle combinations of two mirrors for reading one packet located at point 10.

FIGS. 7 and 8 are a schematic representation and a perspective view, respectively, of another embodiment for reading packets of information within a storage material according to the present invention.

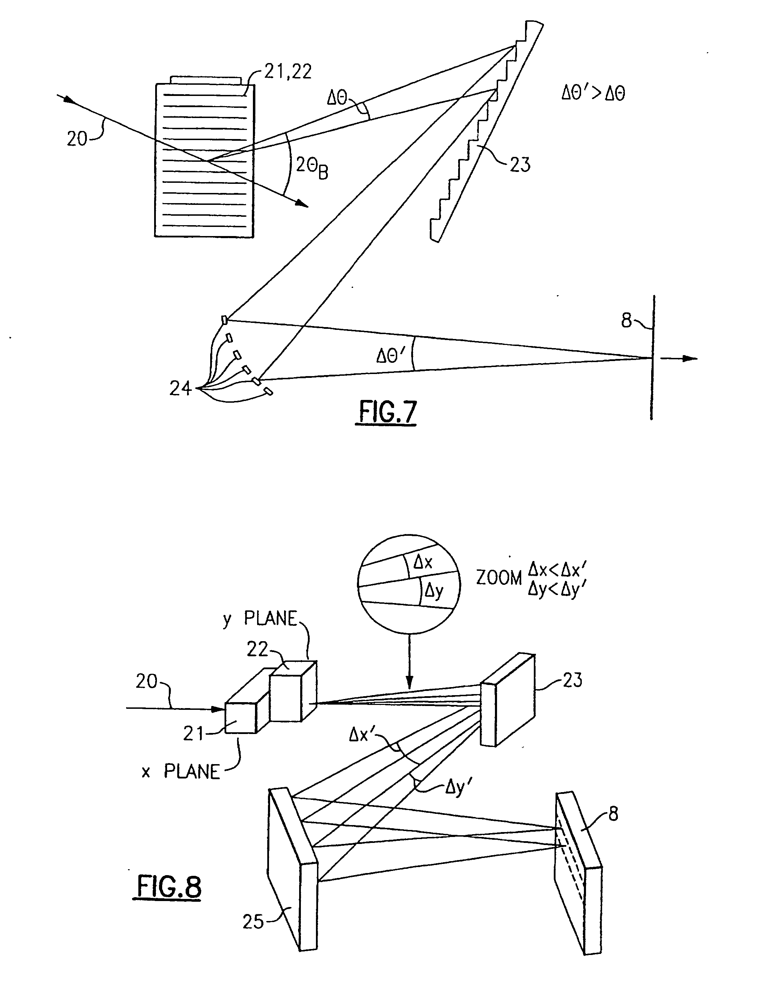

FIG. 7 is a schematic representation of an embodiment for reading packets of information using a plurality of micro mirrors according to the present invention.

FIG. 8 is a schematic representation of an embodiment for reading packets of information using a MEOMS device according to the present invention.

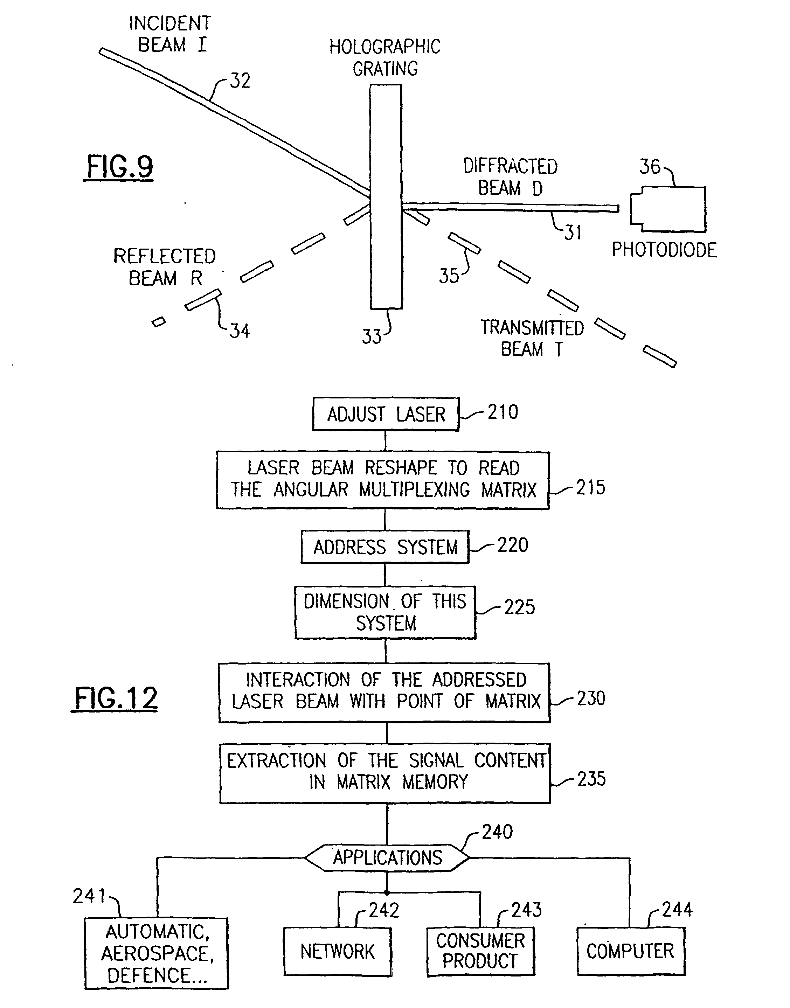

FIG. 9 is a schematic representation of an apparatus for measuring the diffraction efficiency of a holographic grating.

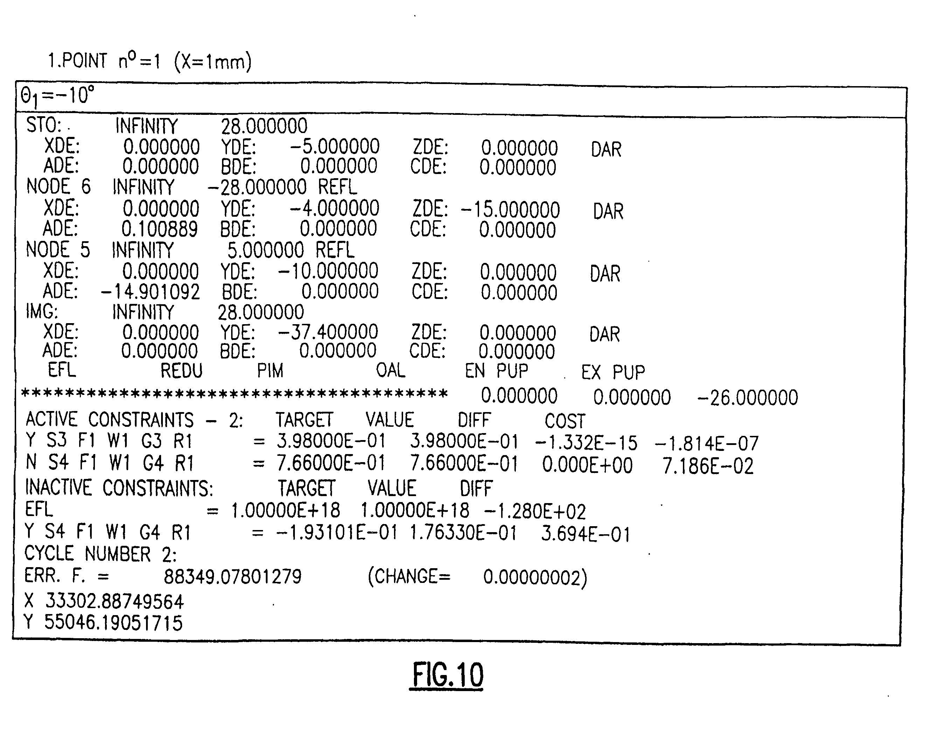

FIG. 10 shows calculated values of the rectangular coordinates and angle where the laser beam is positioned on the storage medium.

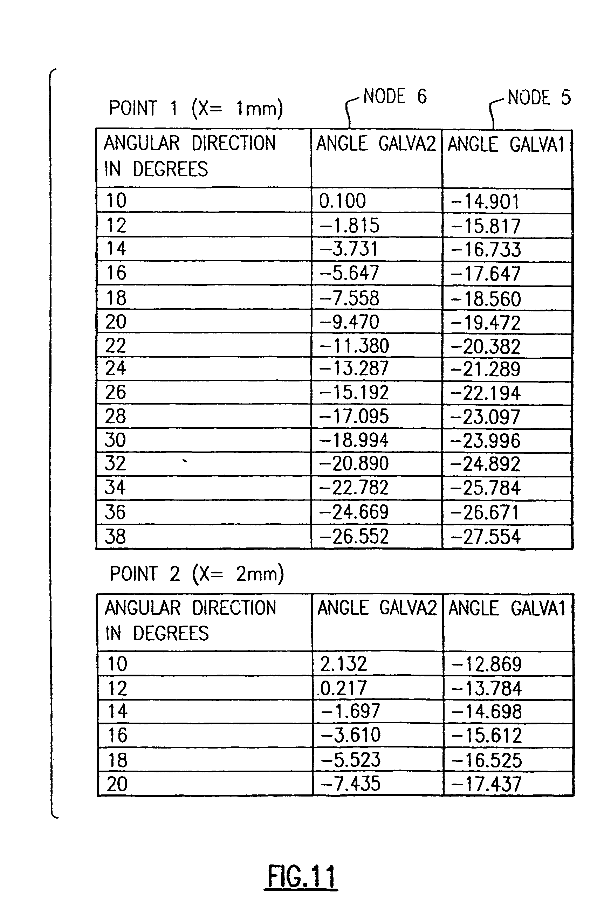

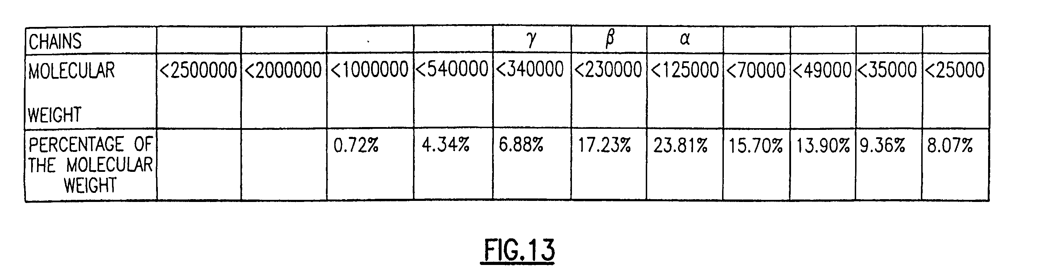

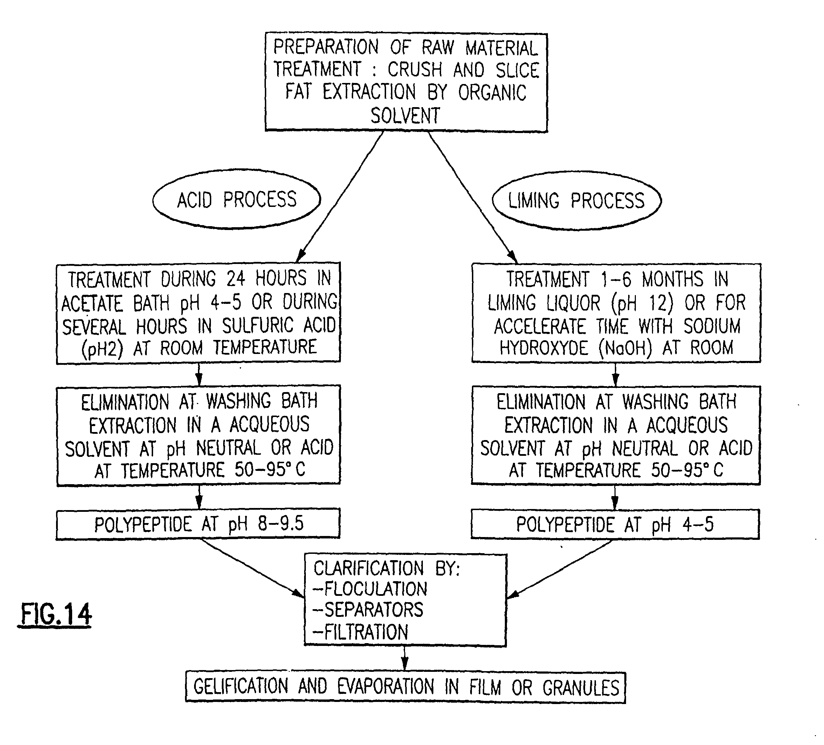

FIG. 11 shows calculation of galvonometer actuator values as a function of rectangular coordinates and angle.

FIG. 12 is a block diagrams representative of the read phase according to the present invention.

FIG. 13 shows a molecular mass distribution of an industrial grade collagen according to the present invention.

FIG. 14 shows an industrial process of polypeptide production according to the present invention.

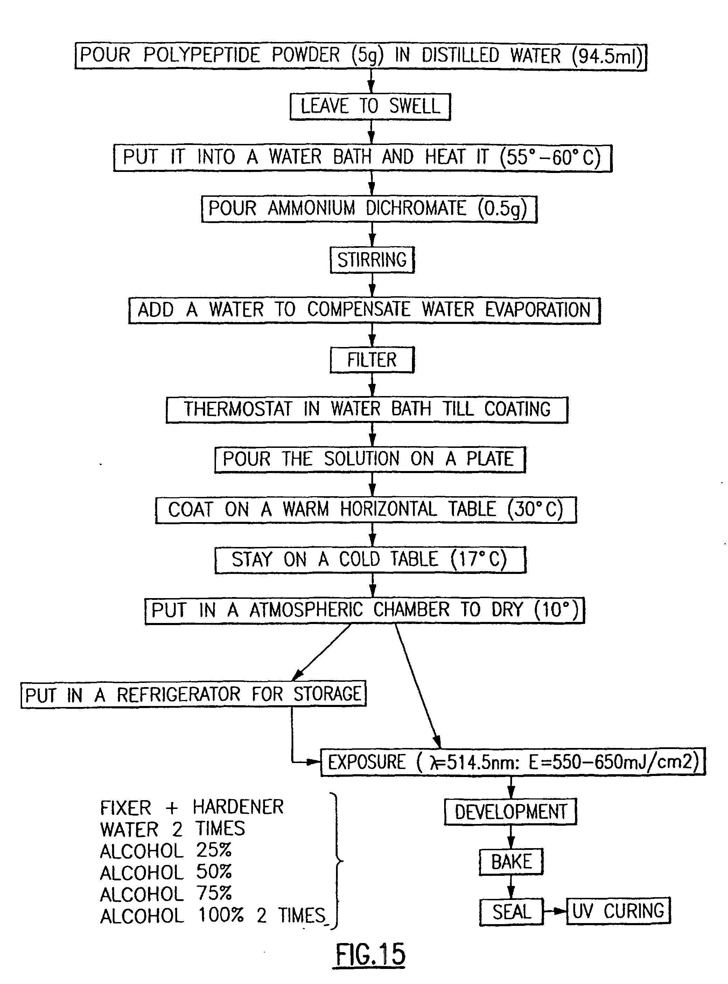

FIG. 15 shows the steps of a method for making polypeptide material according to the present invention.

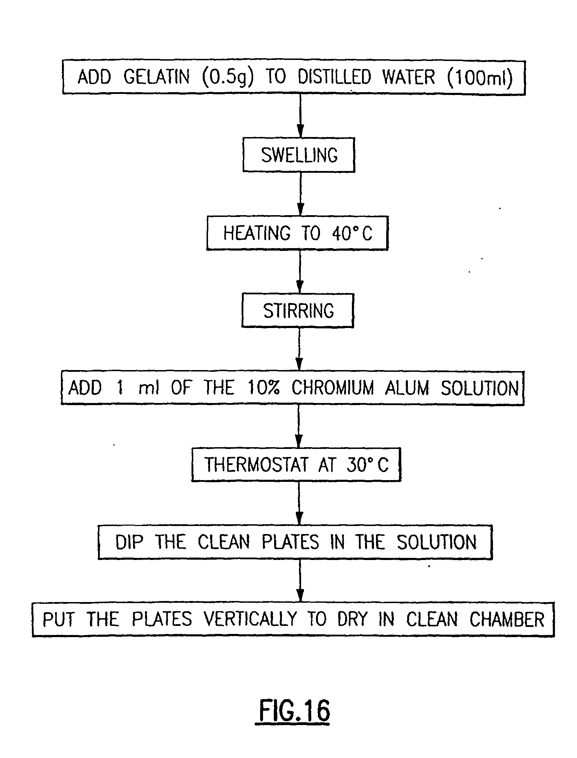

FIG. 16 shows a process for the pretreatment of glass or plastic plates to enhance adherence of doped polypeptide to the plates according to the present invention.

## DETAILED DESCRIPTION OF THE INVENTION

A photonics data storage system according to the present invention is described comprising a recording (storage) material, a data recording/storage apparatus for recording information on this storage material, and an addressing/data reading apparatus for reading the recorded information from this storage material. The photonics data storage system overcomes the limitations of the previous holographic systems discussed in the prior art.

The material

A holography system according to the present invention is described comprising a recording medium (also referred to as a photonics data storage medium, recording material, data storage material, volume holographic memory, data storage recording medium, storage material and polypeptide recording material), a data recording/storage apparatus for recording information on the recording material and an addressing/data reading apparatus for reading the recorded information from the recording material.

Referring to Fig. 15, the steps of one of the embodiments of the present invention is illustrated. Dry polypeptide powder is mixed with distilled water to yield about a 5% polypeptide mixture. The mixture is allowed to sit to have the polypeptide fully swollen by the water. The mixture is then heated in a water bath to a temperature of between about 55 and about 60°C to fully dissolve the polypeptide into solution. A 5 to 10% ammonium dichromate solution is added to the polypeptide solution and stirred to dope the polypeptide. To maintain the concentration of polypeptide in solution, make up water is added to compensate for water lost from evaporation during the heating. After the doping step is completed, the doped polypeptide solution is filtered and then thermostated in a water bath at a temperature of between about 55 and about 60°C for a period of about 15 to about 60 minutes for the purposes of eliminating the thermal memory of the peptide. The thermostatic polypeptide solution is then deposited on a smooth glass or plastic plate or film. The plate is normally on a warm coating table in a clean room environment to form a smooth uniform coat of the doped polypeptide solution on the plate. The table is then cooled to cool the plate and the polypeptide solution to solidify the doped polypeptide solution. The cold plate with the cold polypeptide layer is then placed in an atmosphere chamber to remove the water from the polypeptide layer. This yields the unexposed recording medium. The recording medium can then be placed in a refrigerator for storage or expose as described herein to record information. After the exposure, the plate is developed using a fixer and preferably simultaneously hardened. After the development, the developed exposed plate is washed in at least two water baths and then dehydrated by washing in a 25% alcohol bath, preferably isopropyl alcohol, then a 50% alcohol bath, then a 75% alcohol bath, and finally successively with two 100% alcohol baths to remove all the water from the developed exposed recording medium. The dehydrated recording medium is then baked at about 100°C for about 1 hour to drive off all the alcohol. The exposed surface of the dehydrated recording medium is then protected by gluing a glass or plastic plate to the surface or by coating the surface with a varnish. If varnish is applied, the varnish is preferably cured by ultraviolet light.

All the above steps from the point of adding ammonium dichromate to the polypeptide solution through the development is done in the dark or, at most, in red inactinic light. Exposure to actinic radiation or light prior to development or during or after doping with ammonium dichromate exposes the recording medium and destroys its ability to record data.

FIG. 16 shows the preferred pretreatment of the glass plates (every plastic plate has a specific optimal processing) to enhance adherence of the doped polypeptide to the plate. The adhesive is formed by adding 0.5 grams of polypeptide to distilled water (100 milliliters). The gelatin is allowed to swell in the distilled water. The resulting mixture is heated to 40°C to form a gelatin solution. One milliliter of a 10% chromium alum solution is added and stirred into the gelatin solution. The resulting polypeptide solution doped with chromium alum is thermostated at 30°C. Clean plates are dipped in the resulting solution and positioned vertically to dry in a clean chamber. The gelative solution upon drying on the surface of the plate forms an adhesive surface which readily bonds with the doped polypeptide.

The Polypeptide Material

The polypeptide material for use as a recording medium, according to the present invention comprises a solution of chromium-doped collagen based polypeptide, in which solution the alpha and beta chains making up the polypeptide are predominantly present in proportions such that the alpha/beta ratio is greater than 1 and advantageously between about 1.2 and about 2.1. This polypeptide material of biological origin undergoes a preparatory treatment before being coated on a substrate. The recording medium is maintained and stored in an atmosphere at a defined temperature and at a defined relative humidity before use.

The polypeptide starting material, of average molecular weight between about 120,000 and about 150,000 Daltons, preferably about 120,000 Daltons, is obtained from a base material consisting of a collagen. A method of producing the polypeptide material for the recording or information medium according to the invention will now be described below in greater detail.

This process consists firstly in solvating and swelling a polypeptide of biological origin in water, preferably deionized water, for a period of about two to about ten hours at room temperature. The polypeptide is normally available as a dry powder. Polypeptides are selected that have the desired alpha chain to beta chain weight ratio, the average molecular weight, that can form gels of the desired gelling power and that have the desired viscosity as described above. The partial solution thus obtained is heated to a temperature of between about 40 and about 60°C, until the polypeptide has completely dissolved. The dopants are then added, especially the chromium VI salts. The aim is to completely dissolve these dopants or additives.

Collagen, Hydrolysis

Conventionally, when collagen is converted into a water soluble polypeptide, for example by alkaline or acid hydrolysis, denaturation occurs, resulting in the loss of the helical structure of the collagen. The collagen is produced from a number of animal sources, utilizing bones, hides, and tendons of animals. Depending upon the source of the collagen, the material characteristics of the resulting polypeptide will be slightly different because of the molecular makeup of the polypeptide from the collagen source. Even collagens from the same type of animals can vary depending upon the geographical habitat of the animal. In addition, manufacturing processes can induce differences in the resulting polypeptide.

Polypeptides produced from collagens are commercially available and are used in the food, drug, cosmetic and photographic film industries. The best results we have found to date come from polypeptides produced by the hydrolysis of pork skin collagen and poultry leg collagen. Such polypeptides are readily available because they are used in the cosmetic industry. Polypeptides have been acquired from several producers and used in the present invention with success. The polypeptide from pork skin collagen produced by the SKW Company located in South France which has an alpha chain to beta chain weight ratio of between about 1.2 and about 1.3 has been found to be very suitable. We have used polypeptides from chicken and turkey collagens having alpha to beta weight ratios of about 1.5 and from about 2.0 to about 2.1 produced by alkaline hydrolysis.

When it is available, polypeptides produced by genetic engineering using bacteria will probably produce a consistent and standard polypeptide that will eliminate most variances in the polypeptide. At the present time, this is not available in commercial quantities, although small batches have been made on the research scale. We have not tested these polypeptides. We found that commercial polypeptide based collagens, i.e. polypeptides derived from collagens, can also be found in the chemical catalogs of SIGMA MERCK KNOX NITTA KONICA, and CRODA COLLAIDS. We have not tested these polypeptides.

The molecules in collagen consist of amino acids linked by peptide bonds that are associated in a triple helix. The molecules of collagen from different sources differ by the amino acid sequence on the helix and the location of each amino acid on the helix. Amino acids can be repeated many times on the helix. The collagen molecule architecture is organized around a backbone. Every third carbone is occupied by a glycine. Amino acids that are most commonly found on the collagen molecule chain are glycine, proline, hydroxyproline, and alanine. Those are the most common amino acids, although many of the other amino acids are normally found on a collagen molecule.

Collagens are not pure materials as they have many other chemical constituents, including lipids and some minerals. Some of these impurities are carried over to the polypeptide following a hydrolysis and separation of the water soluble polypeptide. Minerals are normally present at less than 2% and usually less than 1% by weight in the polypeptide.

The Polypeptide, Hydrolysis

Although any collagen based polypeptide can be utilized in the present invention, we find that the polypeptides of high purity industrial grades collagens are the most suitable, especially the collagens of type I (type I collagens essentially come from mammalian sources), and the collagens from chicken and turkey.

About half the molecular weight will be between around 34,000 and 125,000 Daltons. See Fig. 13. As mentioned above, the polypeptide is produced by the hydrolysis of collagen. See Fig. 14 illustrates a typical industrial processes. The hydrolysis can either be an acid hydrolysis or an alkaline hydrolysis. Each manufacturer of collagen polypeptides utilizes their own hydrolysis method. They select the conditions, such as the loading of the collagen, the concentration of the acid or alkaline, the specific acids or alkalines used for the hydrolysis, the temperature of the hydrolysis, the duration of the hydrolysis, and the like, to obtain a polypeptide product which is water soluble and has an average molecular weight of around 120,000 Daltons. By modifying the conditions of hydrolysis, the manufacturer can increase or decrease the average molecular weight and the molecular weight range of the resulting polypeptide. Although other polypeptides having other average molecular weights can be employed, and although the range of molecular weights in the polypeptide can be from almost a million to less than 25,000 Daltons, we find that the polypeptide having an average molecular weight between 120,000 and 150,000 Daltons works satisfactorily in the present invention, preferably about 120,000 Daltons.

Alpha and Beta Chains

Two basic polypeptide components are obtained during hydrolysis, called alpha and beta chains. Another component, the gamma chain, may also be obtained.

The alpha chain are components with an average molecular weight of about 95,000. The beta and gamma chains are components having respective average molecular weights of about 190,000 and about 285,000, the gamma component being similar to tropocollagen. The alpha chain is that portion of the polypeptide having a molecular weight of more than 70,000 Daltons and less than 125,000 Daltons. The beta chain is that portion of the polypeptide having a molecular weight of more than 125,000 Daltons but less than 230,000 Daltons. The gamma chain is that portion of the polypeptide that has a molecular weight of more than 230,000 Daltons but less than 340,000 Daltons. Other residual components may also be produced during hydrolysis.

According to one characteristic of the invention, the material used to prepare the recording medium or storage memory is based on a polypeptide in which the alpha/beta chain weight ratio is greater than 1 and advantageously between about 1.2 and about 2.1. It is shown in fact that, with such a ratio, the diffraction efficiency is increased, this quantity itself being defined as the ratio of the energy of the diffracted signal to the energy of the incident light. Although we have found that the weight ratio of the alpha and beta chains of greater than 1 is essential for the practice of the invention, we have also found that the high molecular weight constituents give the material its photonic sensitivity. We believe the reason for this is that during the gelation or gel formation, it is easier to gel from nonseparated polypeptide molecules (higher molecular weight constituents) that have a triple helix architecture than for a simple helix polypeptide molecules (lower molecular weight constituents) that have a simple helix, such as the alpha chain. By increasing the weight ratio of the alpha to beta chains, we achieve a lower diffraction efficiently.

If we change the origin of the collagen, for example switching from pork collagen to chicken or turkey collagen, we have a change of the optimal ratio for diffraction efficiency because the acid hydrolysis of pork skin gives a weight ratio of alpha to beta chains of 1.2 to 1.3, while acid hydrolysis of bones (chicken or turkey collagen), give an alpha to beta chain weight ratio of about 1.5. A different relationship with diffraction optimization exists also. Photonics parameters as light sensitivity depends on the choice of polypeptide molecule. The diffraction efficiency adjustment (related for instance to exposure time and photonics energy level used) will not be the same depending of the origin of the polypeptides molecules for instance it will different (slightly) between pork and chicken and turkey polypeptide.

During the acid hydrolysis of collagen, transverse bonding is not destroyed. So when alpha and beta chains are produced, gamma chains are also produced. In alkaline hydrolysis, covalent crosslinks between collagen chains are broken and more alpha chains can be produced than in acid hydrolysis. The relative percentages of the alpha, beta and gamma chains depends on the collagen and the specifics of the hydrolysis process which is controlled by the commercial manufacturer. There is a molecular weight distribution connection to the distribution of the alpha, beta and gamma chains. See Fig. 13. In order to get a more controlled and standard polypeptide from commercial collagen sources, it may be possible to use enzyme digestion. We have not explored this route at present.

During commercial preparation of the polypeptide from collagen, the producer can exert some control over high molecular weight and low molecular weight components by removal by filtration, centrifuge separation, and differential separation by cooling the polypeptide aqueous solution. At the present time, it is not possible to produce a polypeptide comprising only the alpha, beta and gamma constituents. The hydrolysis temperature also has an effect on the distribution of the alpha, beta and gamma chains also. Lower temperature hydrolysis favor higher molecular weight fraction production, while higher temperature hydrolysis increases the lower molecular weight fractions and favors alpha chain production.

### The Polypeptide Gel

The polypeptide material used according to the invention as a recording medium is in the form of a gel supported on a substrate. A polypeptide gel is a saturated form of soft material that follows the sol formation out of a liquid where water is a solvent and polypeptide is substrate. The gel can have impurities or defects. The defects can arise from the structure of the gel and the impurities can consist of foreign materials coming from the collagen. In the practice of the present invention, tolerance exists for both these criteria.

It has been demonstrated that the ability of the material to record and store, under the optimum conditions, the holograms representative of the data to be recorded depends on the quality of this gel. The viscosity and gelling power of the polypeptide influence the photosensitivity of the doped polypeptide. Thus, the viscosity and gelling power are critical for reaching optimal results of the present invention. The higher the viscosity and the gelling power of the polypeptide, the higher the energy exposure must be. The gel strength of this polypeptide gel may be defined by a quantity called the "bloom strength". This quantity allows the number of hydrogen bonds per unit volume to be determined. It correlates directly with the polypeptide gelling power. Advantageously, the gel strength of the polypeptide lies between about 90 and about 300 bloom, and more specifically close to about 250 bloom, so as to obtain optimal recordings. The gel strength is determined by means of a gelometer, using a method according to an AFNOR NF V 59-001 or BSI BS 757 (1975) standard. The nature of the gel may also be determined by melting point, pH, impurities in the gel, molecular weight distribution, average molecular weight, and viscosity. The gel strength is measured before doping of the polypeptide with surfactant, Cr VI, hardener, plasticizer, and the like.

The viscosity of the polypeptide is also an important criterion in the present invention. The viscosity of the polypeptide constitutes a factor involved in the quality of the recording medium. The viscosity is directly related to the length of the molecular chains making up the polypeptide material. In our early investigation, we measured the viscosity of the polypeptide at between about 3 and about 4 centipoises. However, more recent results show that the viscosity is closer to around 3.5 centipoises measured by the Standard Method. The viscosity measurements were made in milliPascal seconds. Viscosity measurements were done at 60°C with a 6.67% by weight polypeptide concentration in water. The time necessary for a 6.67% by weight polypeptide solution to flow through a capillary viscosimetric pipette by the Standard Method for the sampling and testing of gelatins was used ("Standard Method" herein). The viscosity measurements are prior to doping the polypeptide.

The polypeptide gel is formed by taking the polypeptide material, which commercially is normally in the form of solid flakes or powder, and mixing the polypeptide material in deionized water. The polypeptide is allowed to remain in the water for 2 to 10 hours. During this time, the polypeptide dry material absorbs the water and swells and forms at least a partial solution. The polypeptide is then heated to a temperature between about 40 and about 60°C. to form a polypeptide solution. The polypeptide solution is produced in concentrations from about 5% to about 10% by weight dry polypeptide. The polypeptide solution is then treated or doped with chromium VI ion as described below.

Polypeptide Doping Stage

As already mentioned, the polypeptide is doped with a chromium VI salt. The polypeptide is doped in solution with a soluble chromium VI salt solution containing 5 to about 20% by weight salt, preferably about 5 to 10% by weight salt, using water soluble salts such as ammonia dichromate, potassium dichromate, and the like. Pyridine dichromate can also be used. This is the most light sensitive of the dichromate salts, but its use decreases the shelf life of the recording medium. The dichromate salt solution is poured into the polypeptide solution (about 5% to about 10% by weight polypeptide) at a temperature from about 55 to about 60°C. The addition is a mass addition although incremental additions can also be used. The resulting doped solution is agitated, i.e. stirred. We have found stirring for 10 to 15 minutes to be sufficient. The chromium VI salt doping is done in the amount of about 5 to about 15% by weight of the dry polypeptide used, preferably about 10% by weight. The chromium VI salt doping can be done in amounts of less than 5% or in amounts in excess of 10%. When doped with the less than 5% by weight of the chromium VI salt, the doped polypeptide is not as actinic light sensitive as the polypeptides doped with a higher loading of the chromium VI salt. When doped with less than 5% by weight of the chromium VI salt, more photonic energy is required for recording than for polypeptides doped with from about 5 to about 10% by weight of the chromium VI salt. The polypeptide can be doped with up to 25 to 26% by weight of the chromium VI salt. However, at the higher loadings, surface crystallization of the doped polypeptide can occur. A loading of 25 or 26% chromium VI salt is not usable because polypeptides saturate chromium ion which renders the polypeptide virtually useless for recording for the present invention. A chromium VI ion concentration greater than 15% by weight of the polypeptide can result in saturation of the absorption of the light by the polypeptide layer. The consequence of this is the appearance of noise. Other chromium VI salt loadings may be possible, but we find that for a doped polypeptide coating on a recording medium of 30 microns in thickness, a doping of about 5 to about 15% of the chromium VI salt is quite suitable for the practice of the present invention. The final polypeptide doped solution will preferably have a concentration between about 100 and about 200 mg of chromium VI ion per 100 ml of 5% polypeptide solution to about 200 to about 400 mg of chromium VI ion per 100 mil of polypeptide solution. The Cr VI doping and all subsequent steps through development are done in the dark, although red inactinic light can be used. The Cr VI doped polypeptide is sensitive to actinic radiation or light.

It has been demonstrated that the latent image, that is to say the holographic data recorded in the polypeptide of the recording medium, is due to the intermolecular transfer of charges (electrons) from the polypeptide to the chromium VI (Cr +6), which undergoes a reduction reaction to chromium V (Cr +5). At the same time, the polypeptide is oxidized. During the development step which follows the recording step, the chromium V (Cr +5) is in turn reduced to chromium III (Cr +3), which is complexed by the polar groups of the peptide chains, forming stable bonds of a covalent nature. The chromium VI remaining unreduced in the constitutive matrix of the material is removed during fixing and washing steps with aqueous fixer and water, described in greater detail below.

Again according to another advantageous characteristic of the invention, the polypeptide doped solution used may also be hardened prior to or after the Cr VI doping by means of hardening agents, such as an aqueous chromium III solution employing a soluble Cr III salt in an amount of about 0.5% by weight of dry polypeptide. The hardening agents are intended to improve the mechanical integrity of the polypeptide. Hardening also effects the optical properties of the recording medium. The hardening product reacts with the ionized parts of the polypeptide molecule, creating covalent bonds and forming a three-dimensional network. Preferably hardening is done during fixing.

This hardening agent may consist of soluble chromium III salts or other soluble hardening agents for polypeptides such as metal ions comprising salts of aluminum, cobalt, iron, platinum, titanium, zirconium or the like, or with organic hardeners such as aldehydes (formaldehyde, glyoxal, glutaraldehyde, crotonic and succinicaldehyde, acroleine), aldehyde carboxylics (glyoxylics), polymeric aldehydes (para aldehyde), ketones (diacetyl, 3-hexene-2,5-dione, quinone), carboxylic and carbonic acid derivatives, sulfonate esters and sulfonyl halides, epoxides (butadiene dioxide, ethylene glycol diglycidic ether) aziridines, active olefins (divinyl sulfone, divinyl ketone triazines), isocyanates, carboiimides, polymeric hardeners, and the like. These other types of polypeptide hardeners have not been tested for this invention and the use of them may require some adjustments to the process with regard to concentrations of hardeners, time of treatment, temperature of treatment, and the like.

The polypeptide doped solution may be treated with a surfactant, such as a surfactant of the fluorocarbon type. The use of such a surfactant helps to reduce the surface tension of the polypeptide solution. Such a surfactant may have a formula of the semi-developed form below:

$$R_F\text{\_\_\_\_}X$$

in which $R_F$ denotes a stable fluorine-containing radical and X denotes a stabilizing or hydrophilic group. The surfactant improves the surface finish of the doped polypeptide layer and, at the same time, improves the coating of the latter onto a substrate, allowing it to be automated. The surfactant is a nonreactive material in the polypeptide solution that by reducing a tensile strength of the polypeptide solution provides for better coating. A 3M product: CF129 has been found quite suitable for use in the present invention. The composition of CF129 is reported to be the following: 51% potassium fluoroalkylcarboxylates, 31% water, 14% Z-Butoxyethariol, 4% ethylic alcohol. We have added sufficient surfactant to give a loading around 0.005% surfactant by weight for each 100 milliliters of the polypeptide solution. If the proper amount of surfactant is not added, the polypeptide coating or resulting layer may not glue or adhere to the substrate satisfactorily. We have found that the above amount of the 3M CF129 surfactant gives satisfactory results virtually every time. Other surfactants, such as, a surfactant that is soluble in the polypeptide solution and polypeptide gel, and that does adversely effect the exposure sensitivity of the recording medium or the quality of the stored data in the exposed and developed recording medium, can be used. A slight decrease in exposure sensitivity and quality of the stored data can be tolerated. Preferably the surfactant does not chemically react or bond with the chromium or other constituents of the polypeptide solutions and gel.

The way we conduct the doping process comprises, we first add the surfactant, then dope the polypeptide solution with the chromium VI aqueous solution, and finally add the hardener, when we harden at this stage. This order may not be crucial and it may be possible to have other orders of addition, but we have not investigated them.

A plasticizer of the glycerol type may also be added to the polypeptide solution. The plasticizer we use is a glycerol. The amount of glycerol must be controlled because its effects at low temperature (photonic data volume output is lowered and blurring can occur below 50°C). We have added 5% by weight glycerol to the polypeptide solution. We have added it last following Cr VI doping or hardening, whichever is last. The order of addition may not be critical. We have successfully practiced the present invention without the use of glycerol or other plasticizer.

A plasticizer that is soluble in the polypeptide solution and polypeptide gel, and that does adversely effect the exposure sensitivity of the recording medium or the quality of the stored data in the exposed and developed recording medium can be used. A slight decrease in exposure sensitivity and quality of the stored data can be tolerated. Preferably the plasticizer does not chemically react or bond with the chromium or other constituents of the polypeptide solutions and gel.

The solution thus obtained following the addition, or treatment with, the dopant is then filtered and thermostated at a temperature between about 55°C and about 60°C for a period of about 15 to about 60 minutes for the purpose of eliminating the thermal memory of the polypeptide. As stated above, this is done in the absence of actinic light. The heated solution is then filtered. Filtering can be done with a Whatman filtering paper having 20 to 25 micrometers pores (filter no. 541). Gravity filtering has been found quite satisfactory although pressure filtration or vacuum filtration can also be employed if desire. The resulting filtered solution is then deposited on a substrate as described below.

The polypeptide is an organic material and can be an organic food for bacteria and fungi over a wide temperature range. It has been found that some bacteria rapidly attack polypeptides at temperatures between 50 and 60°C. Higher temperatures treatment are not desirable because of possible bacterial attack and possible hydrolysis of the polypeptide. Lower temperatures can be used, but temperatures of 40°C or lower the sol gel transition point for polypeptides is reached which it makes it difficult to dissolve all the polypeptide in solution. Thus, temperatures close to 60°C. are preferred. However, to minimize bacterial attack at 60°C, it is preferred that the polypeptide solution only be maintained at this temperature for about 15 minutes at the most. It is believed that the Cr VI doping and Cr III hardening have antibacterial and antifungal properties. In our clean room, we have never noticed a bacteria attack at room temperature (20°C.) even after 3 days of storage. At higher temperature around 50°C. we have never noticed a bacteria problem.

We believe the 55 to 60°C. temperature is necessary for dissolving any last polypeptide aggregates that could have been formed at lower temperature, such as storing the doped solution in a refrigerator prior to coating. It is preferred not to store the polypeptide solution, but to go directly from swelling to the making of the polypeptide solution with the doping treatment and the coating step. It may even be better to start from the production of the polypeptide by hydrolysis and proceed all the way to the coating step.

The doped solution thus obtained is ready to be deposited, especially by coating, on a glass or plastic substrate. We have found that a polypeptide loading of about 5% by weight in the solution gives satisfactory deposition results. However, other loadings may be used, such as from about 3% to about 15% polypeptide solution.

However, prior to depositing the doped polypeptide solution on the substrate, the latter if polished glass plate or plastic plate or film it is advantageously coated with a thin layer of an adhesive, for example a hydrophilic adhesive in nature, so that the adhesive is sandwiched between the substrate and the polypeptide solution. As regards the glass substrate, this adhesive layer can consist of a solution comprising 0.5 g of gelatin and 1 ml of a 10% chromium alum solution in 100 ml of water. We have not found the adhesive coating necessary for float glass. However, adhesive coatings might be needed or desired for some glass plates, such as polished glass plates.

With regard to the plastic substrate, and especially polymethyl methacrylate (PMMA) and polycarbonate substrates, the adhesive can consist of a solution containing cellulose. More precisely, the cellulose is in the form of nitrated carboxymethylcellulose (NCMC). An adhesive solution comprises 1.5 parts by weight of methyl vinyl ether/maleic anhydride copolymer, 0.5 part by weight of NCMC and 98 parts by weight of 2-methoxyethanol has worked well. The surface of plastic plates or film can also be treated with oxygen plasma or chemical vapor disposition using plasma reactions to improve adhesion.

The use of such an adhesive layer promotes the attachment of the layer of polypeptide material to the substrate.

When a gravitational coating method is used, a suitable amount of the polypeptide solution is actually coated on the substrates; the final thickness of the coating following drying is dependent upon the concentration of the solution and the amount deposited.

We normally deposit about 6.5 ml of doped solution (5% polypeptide by weight) per 100 square centimeter of substrate surface to yield a coating or layer about 30 microns in thickness after drying.

A layer of the polypeptide recording medium solution may usefully be spread using conventional devices, such as a doctor knife, roll, nozzle, etc., or else by spinning. The polypeptide coating solution has a polypeptide loading between about 3% and about 15% by weight, preferably about 5%. The polypeptide is added in sufficient amount (a coating 650 to 700 microns in thickness to yield a layer of recording medium from about 30 to about 35 microns in thickness after drying). A 700 micron thickness for a 5% by weight polypeptide recording medium solution is satisfactory and yields a recording medium coating of about 33 microns in thickness after drying.

We believe enhanced recording capabilities could be achieved by having doped polypeptide layers approaching up to 500 microns in thickness after drying. Although layers in the 30 to 35 micron thickness range are easily obtainable, it has not been possible to obtain a homogenous coating having a thickness of up to 500 microns at the present time. In addition to the problem achieving a thick homogenous layer of the doped polypeptide on a substrate, there is also the problem of uniform drying and achieving uniform development of the "image" in a thick recording medium. Besides these two problems, a third problem arises from thick coating and that is the roughness of the exposed surface of the coating. With the coating in the 30 to 35 micron range in thickness, the surface of the coating, applied in a clean room, literally has the smoothness of a polished glass plate. Irregularities, roughness, physical defects in the substrate will reflect on the surface of the doped polypeptide. In order to obtain satisfactory results with regard to recording and reading of the recorded medium, the exposed surface of the doped polypeptide (which is protected with a transparent glass or plastic plate or varnish) must be smooth.

Alternatively, a molding operation may be carried out for thicker coatings, i.e. +35 microns. In this situation, the polypeptide solution according to the invention is deposited as a sandwich between two sheets or plates, such as two glass or plastic sheets or plates, or between a glass sheet or plate and a plastic sheet, or between a metal plate and a glass or plastic sheet or plate. One of the sheets being coated on the inner side of the sandwich with a hydrophobic coating or film, for example of the silane type, e.g. dichlorodimethysilane. For purposes of this invention, plates mean sheets and plates and sheets mean sheets and plates. The hydrophobic coating or film prevents the polypeptide solution and polypeptide gel from adhering to the sheet.

In this situation, the thickness of the final, dried coating is determined by the space or distance placed between the two faces of the sheets and by the concentration of the solution. The space or distance can be fixed by shims between the sheets. The shims can have a thickness of between about 500 and about 1000 microns.

After the polypeptide recording medium solution has been applied to the plate or sheet, the coated plate or sheet is chilled at a temperature below about $10°C$ for a time of about two hours, such as on a chilled coating table, to form a gel. The plate or sheet bearing the polypeptide recording medium gel coating is detached from the coating table and dried. The chilling can be done by using a temperature regulated coating table in a temperature regulated surrounding. The drying is done in a dry atmospheric chamber. A drying temperature of about $10°C \pm 0.5°C$ is employed. No vacuum is necessary, but a vacuum could be useful especially for thicker coatings. Vacuum drying also may be of benefit for hardened coatings. The sheet with the dried recording medium is stored at cool temperatures, such as between about 3 and $5°C$. These same steps can be employed for the molded thick coatings.

The recording radiation on the recording medium according to the invention acts in the following manner.

As already mentioned, when the recording medium is exposed to light, the chromium VI ions are reduced to chromium V and chromium III ions. The latter react with the polypeptide chains and forms a covalent bond therewith. These bonds result in curing of the polypeptide, thus creating a hardness differential between the exposed regions and the unexposed regions of the recording medium. When the exposed recording medium is developed, there is a further reduction of the chromium V ions to a chromium III. The first reduction, the photoreaction reduction, is very fast. The second reduction, the development reduction, is slow. There is also a dark reaction that occurs slowly in the recording medium without light that reduces the chromium VI to chromium III. This latter reaction limits the shelf life of the recording medium. Thus, the recording medium is preferably stored in a refrigerator at a low temperature to maintain the photosensitivity. We have found that chilled ($0°C$.) stored recording medium kept its shelf life for more than a year. The recording medium can be stored as low as $-18°C$. if the recording medium is first desiccated to prevent ice formation. The recording medium is preferably stored in the dark and only exposed, if at all, to inactinic light or radiation until exposed and developed for recording purposes.

The hardness modulation creates a refractive index modulation during the "development" process. After exposing the recording medium of the invention to the recording radiation, the recording medium preferably undergoes a "development" step necessary for optimizing the optical properties of the hologram and stabilizing the exposed recording medium.

This "development" step essentially consists of treating the material in an aqueous fixer solution, a water bath [s], and then in dehydrating solutions. Thus, the irradiated or exposed material undergoes a treatment in aqueous fixer, during which the chromium +6 ions (Cr VI) that have not reacted are removed, and the chromium +5 ions (Cr V) are reduced to chromium +3 ions, leaving only chromium +3 ions (Cr III) linked to the polypeptide. After development, the exposed recording medium is stable to actinic radiation or light.

Conventional photographic (silver halide) fixers can be used. Kodak brand fixer 3000A has been found quite suitable. Before or during this "fixer" step, it is recommended to harden the hologram obtained, for example by a physicochemical process, for the purpose of optimizing the recording medium and its images' stability over time. The post photoexposure development/hardening can be carried out with conventional photographic fixers and tanning agents or hardening agents. Kodak brand tanning agent 3000B has been found quite suitable. If hardening is required after exposure, preferably the recording medium is fixed and hardened in a single step. Although hardening can be carried out during the doping stage, it is preferred to harden during fixing. One volume part of fixer is conveniently mixed with 3 volume parts of water to yield a 25% by volume fixer solution. The tanning agent or hardener is then added to this mixture at the ratio of 1 volume part hardener to 35 volume parts of the fixer solution. Other volume ratios can be utilized.

The fixing step, hardening step and fixer/hardening step are done at between about 20 and about 22°C. Temperatures outside this range can be employed but we have not tested them. We found that fixing and hardening at 28°C made the bandwidth wider. The fixing or fixing/hardening is continued until all of the dichromate is removed (about 3 to about 10 minutes). The undeveloped recording medium is transparent and orange brown in color. Upon fixing or fixing/hardening, it becomes colorless, i.e. the orange brown coloration disappears. The fixing or fixing/hardening time is preferably between about 4 and about 10 minutes.

Other hardening agents, besides Kodak brand tanning agent 3000B, can be used. Each hardener would have to be tested to determine its effect on the exposed plate. Hardening can be measured in a number of ways including: melting point changes, scratch resistance of the polypeptide coating, resistance of the polypeptide coating to boiling, and the like. An estimated value of the most appropriate hardening can also result from the analysis of the swelling of the coating on the plate coming from the amount of water absorbed. Swelling of polypeptide layer is determined by measuring the change of weight between a water swollen doped polypeptide and the dry polypeptide. The swelling is expressed as percent increase in weight $(W - W_o)/W_o\%$. Where $W_o$ denotes the weight of the dry layer and $W$ is that of the swelled layer. A polypeptide swellable up to about 300% is workable in the present invention; preferably the polypeptide is hardened so that swelling is between about 190 and about 210%. It is important to have good control of this hardening step for the final product. An infrared balance can also be used to determine degree of hardening.

If the hardness of the doped polypeptide is too low, there will be a high level of light scattering by the hologram. On the other hand, if the doped polypeptide's hardness is too high, the refractive index modulation is greatly reduced, which goes counter to the desired aim, since a possibility of multiplexing in the recording medium depends directly on this refractive index modulation.

This hardness depends on the preparation conditions of the material, such as the concentration of the hardening solution and the residence time in the hardening bath. The degree of hardening becomes more significant with increased amounts of light energy being used for the recording or exposure. The greater degree of hardening, the greater the decrease in the amount of swelling. Increased hardening also decreases the diffraction efficiency of the recording medium and shifts the Bragg angle.

Following the fixer and/or fixer/hardener treatment step, the recording medium is washed in a sequence of at least two water baths to remove the excess fixer and hardener, if present, from the recording medium. The washing step is conducted between a temperature of about 20 and about 22°C. Other temperatures can probably be used for washing, but we have not tested other wash temperatures. Each washing step takes between about 3 to about 4 minutes and is preferably conducted with agitation to enhance removing fixer and hardener, if any, from the recording medium. The washing can be extended beyond 4 minutes, but it is preferred to do for at least about 3 minutes. After the recording medium is washed, it is subject to a dehydrating step.

During the dehydrating step, alcohol or other water miscible low boiling organic solvent is used to remove water from the recording medium, giving a recording medium having high refractive index modulation corresponding to the interference fringes produced during the exposure.

This dehydrating step must be carried out gradually, so as to ensure uniformity over the entire thickness of the material, i.e. the curve of the diffraction efficiency is symmetric - inside the recording medium layer the fringe spacings are identical. The alcohol or other water miscible solvent absorbs the water and replaces the water.

The use of an alcohol bath makes it possible to remove the residual water from the polypeptide coating or layer. In order to meet the need for gradual removal of this water, it is proposed to immerse the material in four or five successive alcohol baths, containing, for example, 25%, 50%, 75% and 100% alcohol respectively, for respective times of about three minutes for the first two treatments and about five minutes for the last treatments. Preferably the recording medium is treated in two-100% alcohol baths in the last bath treatments. The dehydration is carried out at the same temperature as the fixing and hardening, namely between about 20 and about 22°C. Other bath temperatures can probably be used but we have not tested other temperatures.

Increased water bath temperatures and dehydrating bath temperatures renders the recording medium layer more sensitive to damage. If the temperature of the baths are increased, the degree of hardening of the polypeptide has to be increased. If the bath temperature is too high and the doped polypeptide has not been sufficiently hardened, the doped polypeptide will precipitate giving layer of the recording medium a milky aspect. This can interfere with the retrieval of information from the recording on the recording medium.

After the dehydration step is completed, the alcohol is removed from the recording medium by heating the plate in an oven at about 100°C for about 1 hour. Other temperatures and heating times can probably be used. The temperature must be maintained below a limit temperature. This limit temperature is the one at which the polypeptide has a reconstruction. This reconstruction consists in polypeptide bond changes. These changes induce modifications of the photonic response of the polypeptide that will not have beyond this temperature the optimal characteristic for the recording. The alcohol removal step can be done under vacuum. Methanol, ethanol and isopropanol can be used with good effect. We found the best results were obtained with isopropanol. Methanol is not favored because of its toxicity. It appears that any low boiling inert, water miscible organic solvent can be used, such as acetone also. We prefer isopropanol because it is readily available and less toxic than methanol or acetone. Methanol vapors are very toxic. Although butanol can be used, we found it gave the recording medium small diffraction efficiency.

In the preferred embodiment, the polypeptide employed in making a recording media preferably has the low as possible amounts of lipids and unhydrolyzed proteins as well as dust and metals to ensure good optical quality. The average optical index of the polypeptides employed in the invention have been around 1.5. We have used polypeptides having optical indexes within the range of about 1.49 to about 1.52. Polypeptides having optical indexes outside this range can probably be used. The polypeptide material is clear and transparent. The optical density value of the polypeptide is significant but not critical. Low optical density is preferred. A change in the optical density will induce a modification of the diffraction efficiency. The optical density can be slightly different between the exposed plate and the developed plate. We have attempted to achieve an optical density as high as possible for the exposed image. We also attempt to achieve the greatest possible difference between the optical density of the unexposed regions compared to the optical density (OD) of the exposed regions of the plate.

After the recording medium has been dehydrated and dried, the exposed surface of the recording medium is protected. For recording medium mounted on glass plates or plastic plates, the exposed surface can be protected with a glass plate, clear transparent plastic plate, or with a varnish coating or layer. When the recording medium is deposited on a film, the exposed surface is protected with a coating or deposit of varnish. The protective plates are glued to the exposed surface of the recording medium. The glue and varnish can be UV cured. Protective plates and varnish protect the recording medium from physical damage to minimize the effect of changes in humidity.

The recording medium after the exposure development, etc., can be stored at room temperature or in a refrigerated environment. If stored in refrigerated environment, the recording medium is stored at a temperature above the freezing point of water and the crystallization point of the polypeptide, whichever is higher. When the recording medium is stored in nonrefrigerated conditions, it is stored at temperatures below the melting point of the polypeptide layer.

Ideally, the recordings are made under the same conditions that the recording medium is read. We have found that humidity of 45 to 50% at a temperature of about 21°C quite satisfactory for recording and reading. In order to ensure reproducible results, after removing unexposed plate from the refrigerator, we maintain the plate at room temperature, i.e. the temperature at which the recording is to be done and at the same humidity as the recording medium exposed to during recording. During the recording step, recording medium should not be subject to temperature changes or humidity changes. Similarly, if the recorded recording medium is stored in refrigerated conditions, the recorded recording medium is allowed to stabilize at room temperature. The conditions of reading are preferably under the same conditions of humidity and temperature as used during the recording step.

The recorded recording medium with its protective plate or varnish is very stable and can be stored in actinic light or radiation and at room temperature without any ill effects. The recorded pate once protected can be stored for a very long time in a surrounding having a temperature ranging from 100°C down to -20°C.

The protective glass or plastic plates are glued to the exposed surface of the recording medium employing a glue which will bond glass or plastic to the doped polypeptide. We have used a glue which has a refractive index of about 1.56. Preferably, the refractive index of the plate and glue are close to the refractive index of the doped polypeptide. Likewise, preferably the refractive index of the protective varnish is close to refractive index of the doped polypeptide. The plates are carefully glued to the exposed surface of the recording medium so that no air gaps or air bubbles form between the contact surface of the plate and the exposed surface of the doped polypeptide.

RECORDING PHASE

The recording phase includes, inter alia, choosing the characteristics of the recording material, preparing the recording material, calculating parameters of the addressing system, and recording a light beam modulated with information onto the recording material.

Data recording/storage system

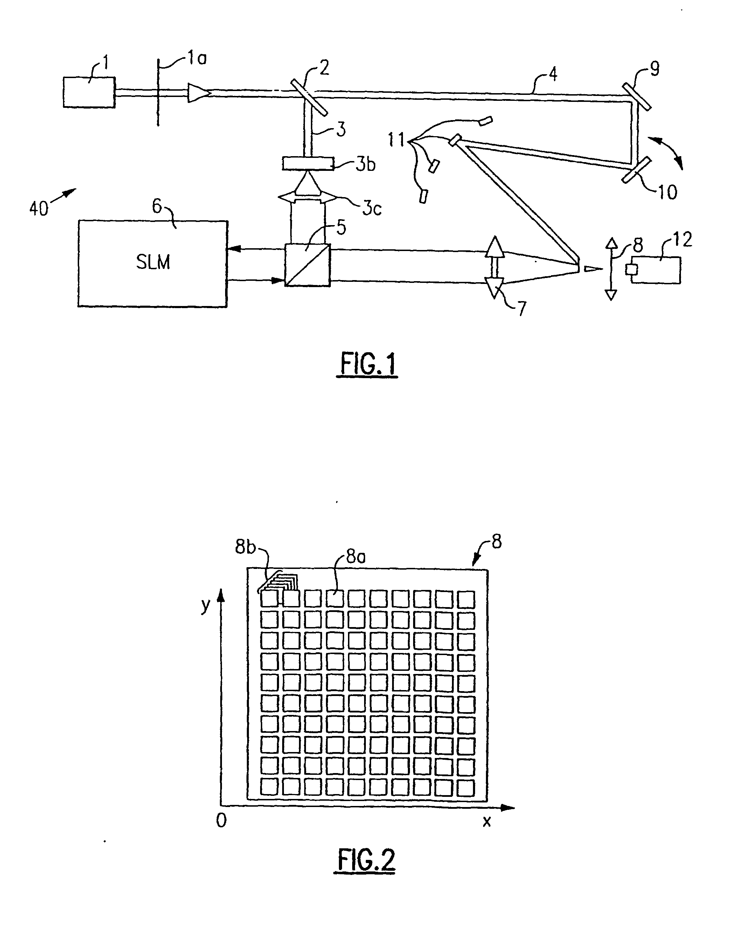

FIG. 1 shows a data recording/storage apparatus 40 for storing information in a storage medium according to the present invention. Laser 1 emits a coherent light beam. For example, laser 1 is an argon laser emitting a beam with a 514 nm wavelength. The time of exposure for the recording is controlled by opening and closing shutter 1 a. The beam emanating from laser 1 is split into two beams by means of a splitter 2 into an object beam 3 and a reference beam 4, respectively. The object beam 3 is filtered by spatial filter 3b and collimated by collimating lens 3c after which it is sent to beam splitter 5. Beam splitter 5 directs the object beam 3 to the display 6 which displays an image to be recorded. The display 6 may be any display for displaying a data packet in two dimensions such as a spatial light modulator (SLM) 6 or liquid crystal light valve (LCLV).

The display 6 comprises, for example, a liquid crystal display screen on which data is encoded in a two-dimensional pattern of transparent and opaque pixels. The data is input to the display 6 via a computer (not shown) or by other digital data or analog origins. The plurality of bits represented on the display screen of the display 6 as a two-dimensional pattern of transparent and opaque pixels is known as a data packet. The data packed displayed is derived from any source such as a computer program, the Internet, and so forth. In an Internet storage application, the packets displayed may be formatted similarly to the packets of the internet.

The object beam 3 becomes modulated by the information to be recorded by means of reflection off of the display 6 (shown) or transmission through the display 6. The modulated object beam 3 then becomes reduced by means of a suitable lens 7 so that the point of convergence of the modulated object beam 3 lies slightly beyond storage material 8.

At the same time, the reference beam 4 undergoes various reflections off the set of mirrors 9, 10 at least one of which can rotate until the reference beam 4 comes to a series of mirrors 11 which are distributed linearly or along a circular arc and the orientation of which will modify the angle of incidence of the reference beam 4 with respect to the object beam 3, again in the region of the storage material 8. Thus, by this mechanism angular multiplexing is implemented. There is formed a diffracted optical image 8a (see Figure 2), or more precisely an image resulting from the interference of the object beam 3 with the reference beam 4, which is stored in the storage material 8. Spatial multiplexing is carried out by mechanically shifting the material 8 so that a data packet is recorded at a different point of the material 8.

In order to be able to have information with the smallest possible dimensions for the purpose of storing it within the aforementioned storage material 8, lens 7 carries out a pseudo-Fourier transform of the object beam 3 that has undergone interference with the reference beam 4. A pseudo-optical Fourier transform is a Fourier transform for which the plane of formation of the Fourier transform has been shifted by 1 to 5% of the focal length of the lens that has generated this Fourier transform. Thus, on the exit side of this lens there is no longer the entire diffraction spectrum but only the central spot, making it possible in particular, by selecting the appropriate lens, to have a spot size of about 1 mm$^2$. It may be shown that the information contained in this signal, coming from a pseudo-Fourier transform, is sufficient and in all cases representative of the information to be stored and subsequently retrieved.

FIG. 2 shows in greater detail the storage material 8 arranged in the form of a flat sheet, herein referred to as a matrix. In this example, the matrix is 1 cm$^2$. Each of a plurality of points on the matrix is defined by its rectilinear coordinates (x, y). The image-forming system 7 reduces the object beam 3 to an image 8a having a minimum size at one of the x, y point of the matrix.

In this case, a 1 mm$^2$ image 8a is obtained by focusing the object beam 3 onto the storage medium 8 centered at its coordinate. Due to this interference between the two beams 3,4 , a diffractive image 8a 1 mm$^2$ in size is recorded in the storage material 8 centered at the coordinates of the matrix. Spatial multiplexing is carried out by sequentially changing the rectilinear coordinates. The object beam 3 focuses on the storage material 8 so that a separate image 8a is recorded at a unique position in the plane defined by its coordinates (x, y). This spatial multiplexing results in a 10 by 10 matrix of diffractive images 8a. Angle multiplexing is carried out by sequentially changing the angle of the reference beam 4 by means of mirrors 11. Angle multiplexing is used to create 15-20 packets of information 8b corresponding to 15 discrete variations of the angle of incidence of the reference beam. A data packet is reconstructed by shinning the reference beam 4 at the same angle and spatial location in which the data packed was recorded. The portion of the reference beam 4 diffracted by the storage material 8 forms the reconstruction, which is detected by a detector array of CCD camera 12. The storage material 8 is mechanically shifted in order to store data packets at different points by its coordinates (x, y).

Method for positioning the recording beam

FIG. 1 shows the data recording/storage apparatus 40 having dynamic devices, for example, the micro mirrors 11, shaping and directing the reference beam 4 at a precise position and angle onto one of a plurality of points 8a of the storage medium 8. A control mechanism, typically a computer (not shown) is used to position the read beam. The control mechanism sends signals to the actuators to position the beam onto the storage medium.

In angular multiplexing, two constraints must be determined. The first constraint is the location which must be determined with sufficient accuracy, in terms of the coordinates (X,Y) of the point of impact of the resulting interference between the object laser beam 3 and the reference laser beam 4 on the storage medium 8. The second constraint is the value of the angle of the reference beam with the plane of the storage medium 8 which must be determined within a predetermined precision. The tolerance within which the angle must be determined (i.e., the precision) depends on characteristics, e.g., the chemical and physical characteristics such as thickness, of the storage material used.

In order to manage these constraints, the present invention modifies the spatial positions of the laser beams, especially the reference laser beam 4, by the positioning of nodes, that is to say points of location of the various activating members involved in the construction of the writing device. The nodes are the points where the laser beam changes shape or direction. The location of these nodal points is determined from calculations carried out using software taking into account the geometrical constraints to which the write device is subject but also the characteristics of the material, e.g., chemical and physical characteristics such as thickness, within which the data will be stored.

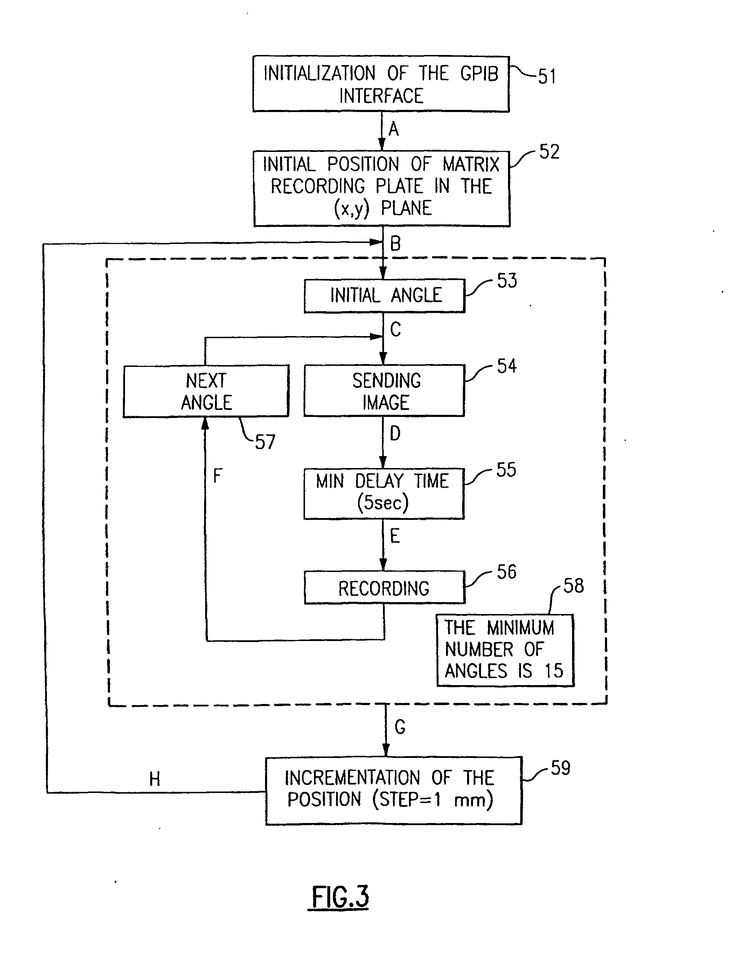

FIG. 3 shows an algorithm that can be used for recording the packets of information on a 1 cm$^2$ matrix.

In the following example, the number of points in the matrix of the storage medium 8 is 10 x 10, each point being capable of containing 15 to 20 packets. In other words, the initial conditions must firstly be defined, that is to say the base parameters, as a function of which not only the location but also the type of activators to be used will be determined. These initial conditions comprise the size of the matrix, the size of the elementary points in this matrix, the nature of the storage material and especially the choice of constitutive molecules, the process for preparing the material (e.g., wavelength sensitivity, coating method), the recording process (e.g., wavelength, temperature, humidity, nature of the substrate), and the post exposure process (e.g., nature of the baths and physical parameters: temperature, humidity).

It is also necessary to take into consideration the operating parameters consisting of: the desired time needed to access the stored information, the type of activators used, the level of miniaturization, and the level of resolution.

The level of miniaturization refers to the size of the addressing system. One embodiment, a "large" system, uses motor activated centimetric mirrors usable for high quality and rather slow recording with every mirror being in the range of a centimeter in size. Another possible embodiment, a "small" system, uses MEOMS (Microoptoelectronomechanical system) package addressing where the solid state mirrors have a surface of around 1 millimeter. The volume of all the addressing systems can range from a few liters to a few cubic millimeters. The complexity of the addressing system is transferable into a chip MEOMS or an association of several chips. A MEOMS is a solid state chip produced by micro lithography and includes micro mechanical electronics and photonics.

From these various items of data, it becomes possible to modify the dimensions of the system, especially with the objective of achieving greater miniaturization of both the recording apparatus and the reading apparatus. In fact, it becomes possible to maintain the predetermined focusing of the read beam, its positioning on the data-carrying matrix, the intensity of the read beam and the ranges of angles of incidence of the read beam at a defined point (X,Y) on the matrix. These ranges of the angles are themselves determined by the initial conditions.

The algorithms, embodied in the form of software, take into account the initial conditions in the case of a change of scale of the reading or recording device.

FIG. 3 shows a method for recording information on a storage medium according to the present invention. In the flow diagram, a "step" denotes an action taken by execution of a sequence of computer instructions of the software. An "action" denotes the subsequent actions taken by the optical system, and in particular actions taken by the actuators.

In step 51, a general-purpose interface bus (GPIB) is initialized. The GPIB bus (not shown) is installed in a computer (not shown) for managing the write phase. The connections between the output of the GPIB bus and the input of various components (see, e.g., Figure 1) and other members for shaping and directing the laser beam are checked for validity. An address can also be assigned to each of these components. Furthermore, the GPIB bus allows the activators to be connected in cascade, by using separate addresses for each component.

In Action A, after checking all the connections, a reply representative of the operation of the components and of the processing of the control signals is sent to a microcomputer.

In step 52, an initial position in the x- and y- plane of the matrix 8 is determined. This step is intended to order all the axes (translation and rotation axes) to adopt the initial position. These positions correspond to the position of the storage sheet of the matrix 8, in such a way that the first point is recorded at the initially programmed point and that the first multiplexing angle is associated with this point.

In Action B, the recording conditions are normalized (e.g., control of vibration; checking that there are no errors in the program).

In step 53, the initial angle is determined. The reference beam adopts the prescribed initial multiplexing angle value, corresponding to the start of the angular multiplexing sequence, which will be set to the value of this initial angle.

In Action C, the actuators move to positions to direct the laser beam at the multiplexing angle value.

In step 54, a packet of data is sent from the computer to the display 6 (e.g., SLM or LCLV) where it is converted to an image. The data is shaped on the display according to constraints corresponding to optimization criteria such as those associated with image quality such as a maximum signal/noise ratio.

In Action D, the image of the packet of information is modulated onto the laser beam.

In step 55, a minimum delay time is determined. The minimum delay time is the minimum time needed to prevent the appearance of a noise level incompatible with quality criteria.

In action E, the reference beam 4 and the object beam 3 intersect in the storage material 8 to form an interference pattern.

In step 56, recording of a data packet occurs at a point defined by the multiplexing angle. The term "point" should be understood to mean a certain complex volume with a mean cross section of 1 mm$^2$. The recording time depends on the mean power and on the wavelength of the laser source used and on the necessary degree of modulation to retrieve the data with an acceptable noise level. The degree of modulation depends on the degree of photosensitization of the material used for storing the data. The exposure time is obtained from response curves. These response curves represent the measure of diffraction efficiency of a holographic grating recorded in the photosensitive material.

In Action F, the angle is changed to record data at the same point in the matrix.

In step 57, the next angle is selected. There is a repetition of the 53-C-54-D-55-E-56-F procedure.

Step 58 represents the repetition loop wherein data is recorded for a plurality of angles at the same point of the matrix. The minimum number of angles corresponding to each multiplexed point in a plane is 15 and the maximum number is more than 20.

In Action G, after multiplexing over all the possible angles for the same point, the procedure passes to the next point by simply changing the (X, Y) position at the matrix.

In step 59, there is an incrementation of the position. Adjustment of the best density of points depending on the operating criteria. In the example described, the (X,Y) matrix spacing is 1 millimeter.

In action H, after having recorded a point in the matrix, the laser beam passes to the next line in this matrix and operations B to G are repeated.

Experiments have demonstrated that the number of multiplexing angles depends on various parameters, including, of course, the nature of the material, that is, the material's diffraction efficiency and ability to limit crosstalk effects.

Flow chart for write phase

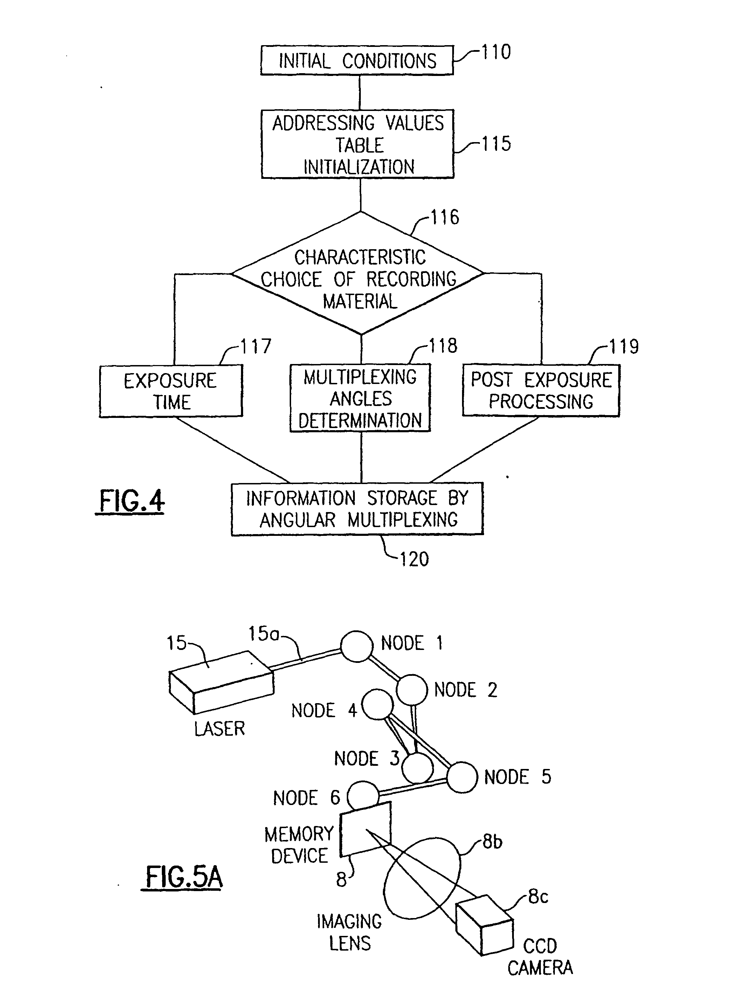

As shown in FIG. 4, the write phase begins at step 110 with a determination of initial conditions, e.g., the point size, spacing between points, number of multiplexing angles, angular spacing, points X, Y density (vertically and horizontally), spectral peak sensitivity of the doped polypeptide. Then at step 115 a table of address values is determined. The address values are the coordinates for positioning the laser beam on the matrix 8. The address values refer to angular values for multiplexing in one point, and X, Y spacing values between points. Then at step 116 the characteristics of the storage material is chosen and from these characteristics parameters of the recording process, such as the exposure time 117, the multiplexing angles 118, and the post processing exposure 119, are determined. The data is then stored in the matrix 8 by angular multiplexing at step 120.

At step 116 the chosen characteristic of the recording material refers to the chemical concentration. This concentration will play a part in determining the optimal level of photonic energy necessary for having an optimal diffraction efficiency. At step 117 for a given concentration range there is a related exposure time range. At step 118, the selected material thickness and chemical concentration will determine the optimal angles of multiplexing. At step 119 to obtain effectively the optimal result it is necessary, in the post processing, to use the appropriate bath with related time and temperature of processing. In step 120, after all of the preceding steps are done, these steps will result in an optimal data storage system operating for a specific angular multiplexing and matrix distribution of the multiplexed recorded points.

Material Tolerancing

The diffraction efficiency is measured by means of a photodiode 36, using the set-up described in FIG. 9. The beam 32 which is incident on the holographic grating 33 results in a reflected beam 34, a transmitted beam 35, and a diffracted beam 31 containing the holographic information. The intensity of the diffracted beam 31 is measured by varying the angle of the incident beam 32. The diffraction efficiency at an angle is equal to the ratio of the intensity of the diffracted beam 31 to the intensity of the incident beam 32. The angular tolerance is obtained from the various values thus obtained. The angular tolerance is defined as being the mid-height width of the diffraction efficiency.

Our approach relies on the fact that the output packet light intensity is only varying slowly with addressing angle variation in a given range. That is to say that the signal remains roughly the same when an angular addressing error exist, for instance, as may be created by a dithering of the scanning system. This allows the use of a fast addressing device. A fast addressing device generally has an angular addressing error that is larger than a slower addressing device.

Angular tolerancing for the addressing device is evaluated by measuring the diffraction efficiency at different angles. To obtain this measurement, the storage plate to be tested is mounted on a rotating bench controlled by a computer. The input beam is referenced through the appropriate angular measuring system. The output intensity is automatically measured at different angles. The angular variation steps are 1/10 of a degree.

By this method, it has been verified that for an error in angle of 2/10 of degree, there is a variation of diffraction efficiency of less than 1%. This difference is not significant for having an effect on the signal quality level. This signal can be applied to a CCD camera that operate with a response accurate with an error of 1%.

This can be compared to other diffractive storage media, such as photorefractive crystal material where an angular multiplexing angle step is about for instance .001 degrees and where an angular error cannot be higher than the half of the angular spacing for instance .001/2 degrees. Above this last angular value significant noise occurs because there is crosstalk caused by several of the subholograms being read at the same time.

In the present invention, tolerancing can be controlled by an appropriate thickness selection, by index modulation, and adjustment in the chemical processing. So it is possible to obtain a material adapted to a given addressing specificity by molecule selection, and an adapted wet processing. A good formula to represent this possibility is :

$$q \sim L/d$$

where

>   q is the angular bandwith;
>   L grating spacing = l/2n sin qB
>   d is thickness
>   qB being the Bragg angle and
>   n is the index of the material.

READING PHASE

The reading phase includes extraction of the signal content from the storage material.

Node addressing design

FIG.5A shows the node addressing design according to the present invention. In this design there are a plurality of nodes having optical elements operating on the laser beam to perform functions such as shaping, focusing, and directing the laser beam. FIG. 5A shows the laser 15 emitting laser beam 15a which is then routed and transformed by nodes 1-6 wherein the laser beam 15a then impinges on memory device 8. The laser beam 15a emitted from the laser 15 is directed to node 1. An optical element located at node 1 filters the laser beam 15a. The optical elements at node 1 may further adjust the laser beam 15a for polarization, collimates the laser beam 15a, and perform diameter fitting of the laser beam 15a. Node 1 is not a dynamic node. Node 1 spatially routes the laser beam 15a to node 2.

The optical elements at node 2 focus the laser beam 15a onto node 3. The location of node 2 is calculated based on the positions of the other nodes in such a way that the beam's focal point lies on a point of node 3. Node 2 is not a dynamic node.

Node 3 is a dynamic node. The optical elements of node 3 route the laser beam 15a dynamically to node 4. The rotation of the laser beam 15a is around a static axis. The laser beam 15a will move following every step calculated out of the point separation (vertical spacing between points).

The location in space of node 4 is stable. Node 4 supports beam defocusing that is calculated in such a way that the beam emerging from the node will be collimated. This is a static node.

Node 5 rotates the laser beam around one axis that is located in such a way that the routing to node 6 will be possible. Node 5 is programmed for sending the laser beam 15a on the target 8 in such way the beam will always reach the node 6 after the node 5. Node 5 is a dynamic node.

Node 6 implements a dynamic angular position of the laser beam 15a. The beam 15a is rotated around an axis, and the rotation is synchronized with node 5 in such a way that the beam will always reach the matrix 8. The accuracy of the pointing will depend on the accuracy of the other nodes, $10^{-2}$ mm is normal.

Node 5 includes an actuator that angularly rotates the laser beam around one axis that is spatially located in such a way that the laser beam will reach node 6. Node 6 include an actuator that will angulary rotate the laser beam around an axis that is spatially located in such a way that the laser beam coming from node 5 will reach node 6. The laser beam output from node 6 will reach the matrix of points constituting the storage medium 8 with a selected angle and axis specific geometrical location. In the plane of the memory, every packet has a xy location on the memory plate and a specific angle of beam addressing. So the addressing is the result of the nodes positioning (spatial) and of the angular selection that is programmed out the recording x y position and multiplexing angles. As a result of the combination of the spatial location of nodes 5 and 6 and the rotation axis positioning and programmed actuators angle selection and positioning of mirrors with an appropriate programming and computer control, the packet will be addressed with the laser beam positioning on the point matrix of the memory plate 8 with the angle corresponding to the selected packet to be read.

The rotation angles and geometry in this nodal system is configured so that there is access to every data packet. Every packet is reached within less than 1 ms. using, for instance, micro galva actuated mirrors implemented in the nodes. After hitting the matrix 8, the beam 15a will deliver one packet of data. The resulting beam is focused by imaging lens 8b onto CCD camera 8c which has a number of pixels adapted to the desired resolution.

Apparatus for control of the read beam

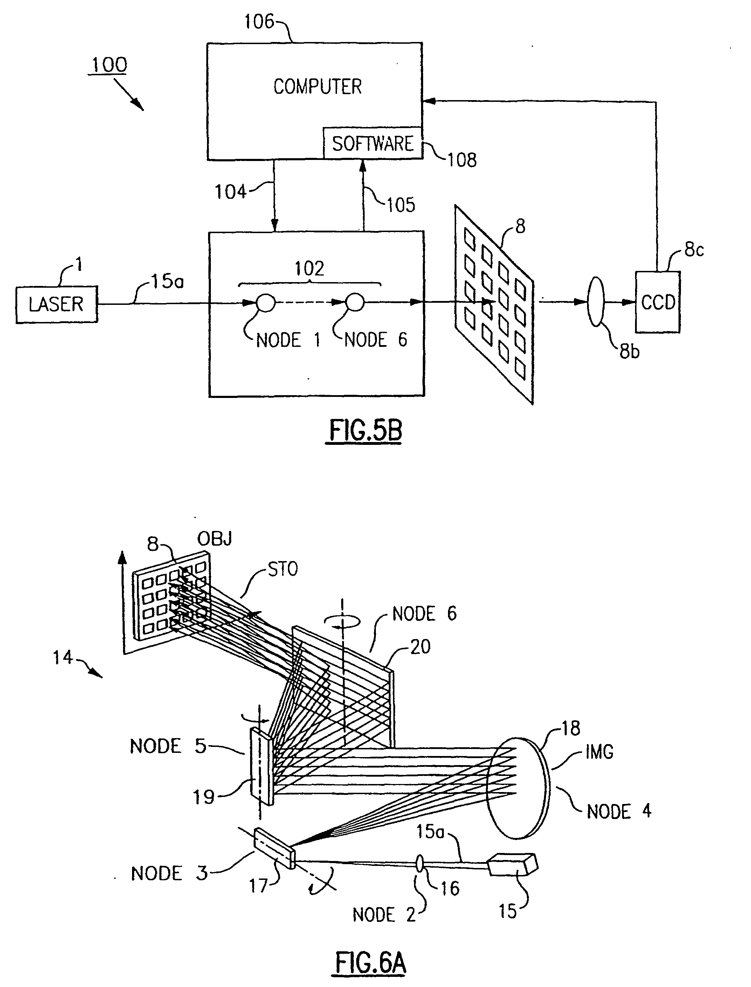

FIG. 5B shows an embodiment of an apparatus for directing the spatial path of a laser beam 15a of laser 1 to a point (x, y) at an angle $\alpha$ on the storage medium 8 according to the present invention. The laser beam 15a is shaped and directed by dynamic or static devices located at the one or more nodes node 1 - node 6. The dynamic devices typically consisting of mirrors or micromirrors associated with a rotating component. They may also consist of acoustooptic components associated with a diffraction grating, or else Kerr or Pockels cells. One of the major difficulties confronting the present invention is how to position the dynamic devices in space and, as a corollary, how to control their orientation.

FIG. 5B shows the control mechanism 100 for the addressing system of Figure 5A used to position the laser beam 15a. The control mechanism 100 sends signal 104 to the actuators 102 which position the beam onto the storage medium 8. During the reading phase, the actuators 102 of the nodes are micro mirrors for shaping and directing the reference beam 15a.

Computer 106 under the control of software 108 sends signals to the activators at one or more nodes. The software 108 receives information via a connection 105 from the activators 102.

The laser beam 15a is directed by the nodes onto the storage medium 8 and from there focused by imaging lens 8b onto CCD camera 8c which has a number of pixels adapted to the desired resolution. The digital output of CCD camera 8c is further processed by the computer 106.

Addressing-read system

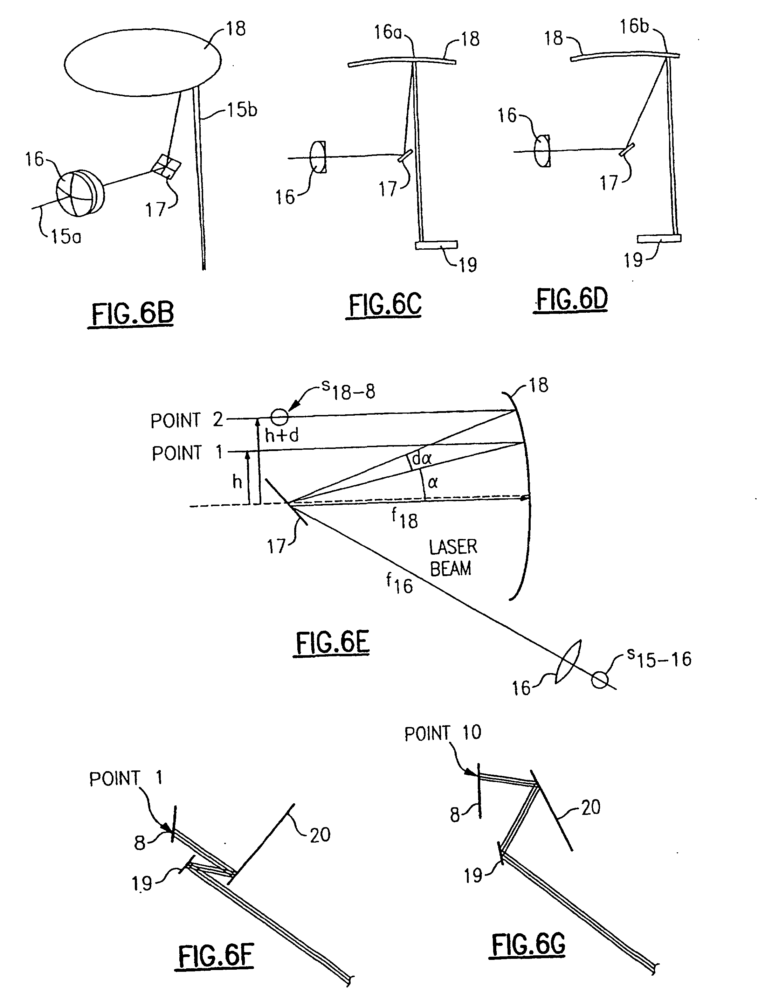

FIG. 6A shows an embodiment of an addressing-read apparatus 14 for storing information in the storage medium 8 according to the present invention. This reading apparatus 14 makes use of mirrors or micromirrors associated with galvanometers, therefore capable of undergoing rotation allowing each mirror to be oriented in the desired direction. These mirrors are positioned at defined points or nodes by software, for the purpose of angularly indexing the wavefront for a point of defined coordinates (X, Y) in the storage medium 8. In order to scan all the rows and all the columns of the matrix 8, two mirrors 19, 20, each associated with a suitable galvanometer, are associated with a concave mirror 18 according to an embodiment of the type described in FIG. 6A.

In FIG. 6A, a read beam 15a emanates from a low-power laser 15. Typically the read beam is less than 5 mW. The laser 15 may be a helium-neon or semiconductor type laser. The read beam 15a is focused by means of a lens 16 onto a first rotating mirror 17, the rotation access of which is horizontal. The mirror 17 is intended to reflect the collimated read beam along the mid-line of a concave mirror 18. The concave mirror 18 in turn reflects the beam onto a rotating mirror 19 associated with a galvanometer (not shown) having a vertical rotation axis. The galvanometer is, for example, of the VM 2000 type from General Scanning (Optical Scanning Products Division, MA 02472). Preferably, the galvonomenter has high rotation speed and high precision. The angle of rotation may be up to 30 degrees with a precision of the order of $10^{-4}$ degrees. This galvanometer can go from one orientation to another in a time of about 0.3 ms and can operate over a 2.5 kHz frequency band. Such a galvanometer is also used in combination with a third mirror 20, also having a vertical rotation axis.

The addressing read apparatus 14 of FIG. 6A is configured according to the node addressing design of FIG. 5A with node 1 not being used, node 2 having lens 16 positioned therein, node 3 having mirror 17 positioned therein, node 4 having mirror 18 positioned therein, node 5 having mirror 19 positioned therein, and node 6 having mirror 20 positioned therein.

FIGS. 6B-6E constitute an enlargement of nodes 16, 17, and 18 in FIG. 6A. In FIG. 6B, the laser beam 15a from laser 15 is directed by lens 16 to mirror 17 which reflects the laser beam 15a to mirror surface 18. The laser beam reflected off of surface 18 is a collimated (parallel) beam 15b. Tilting of the mirror 17 creates another line of scanning. FIGS. 6A-6D are results given by simulations operated by the Code V CAD CAM software from Optical Research Associates. Focussing lens 16 is positioned at node 2. At node 3 is a mirror micro galva 17 (rotation around horizontal axis). A concave static mirror 18 is situated at node 4. FIG. 6B is an enlargement part of FIG. 6A, this part correspond to optical elements 16, 17, 18 in FIG 6A. FIGS. 6C-6D show two extreme rotation of micro galva 17 around a horizontal axis. FIG. 6C shows the first rotation at point 16a of the mirror 18 which is done to read the first line of the matrix 8. FIG. 6D shows the last rotation at point 16b of the mirror 18 which is done to read the last line of the matrix 8.

FIGS. 6F and 6G show some of the angles combination example of galva 19 and galva 20. FIG. 6F shows the angle combination in order to read one packet located in the first point. FIG. 6G shows the angle combination in order to read another packet located in the point number 10.

As shown in FIG. 6B, node 2 contains a focusing lens 16. The position of focusing lens 16 is calculated to have its geometrical center crossed by the laser beam 15a produced from laser 15. The laser beam 15a must be orthogonal to the lens plane.

Referring to FIG. 6E, the optical characteristics of optical element 16 and optical element 18 are dependent. The laser beam size must be 1 mm (diameter size) to fit the size of one matrix point (1mm$^2$). So, the relation between the focal length of the lens 16 and mirror 18 is:

$$\frac{S_{18\text{-}8}}{S_{15\text{-}16}} = \frac{f_{18}}{f_{16}}$$

where

   $S_{18\text{-}8}$: size of the laser beam between mirror 18 and storage medium 8
   $S_{15\text{-}16}$: size of the laser beam between laser 15 and lens 16
   $f_{16}$: is the focal length of lens 16
   $f_{18}$: is the focal length of mirror 18.

The focal lengths $f_{16}$ and $f_{18}$ must satisfy this relation and their choice depends on the size of laser source beam output. The distance between the lens 16 and the mirror 17 must be equal to $f_{16}$ because the laser beam must be focussed on the mirror 17.

Optical element 17 (node 3) is static having one rotation axis that rotates around its horizontal axis.

The center of mirror 18 is located at a distance $f_{18}$ from the center of mirror 17. The axis of symmetry of mirror 18 must be orthogonal to the rotation axis of mirror 17. The horizontal axis intersection must be on the laser focus point that is located on mirror 17.

The beam coming from mirror 18 is collimated having a diameter of 1mm. The laser beam scans one column of memory device matrix 8 by rotation of mirror 17 around its horizontal axis.

During matrix recording, the vertical distance between two consecutive points is 1 mm. The rotating angle of mirror 17 can be calculated to scan any point in one column. The relation is:

$$d\alpha = \arcsin\left(\frac{h+d}{f_{18}}\right) - \arcsin\left(\frac{h}{f_{18}}\right)$$

   h : is the first point vertical coordinate, and
   d : is the distance between the point which must be read and the first point

To read all packets in one point, different angles combination implemented on mirror 19 and mirror 20 must be found. The main constraint here is to keep stable the spatial positions for mirror 19 and mirror 20. So, they have just one rotation possibility around the vertical axis.

The laser beam coming from mirror 18 will be reflected by mirror 19, then by mirror 20. This laser beam will hit one matrix point with a specific angle to read a specific packet. The mirror size implemented on mirror 19 must have at least 1 mm of width because the laser beam size is 1 mm. The vertical size of the mirror is 11 mm high so as to make it possible to read a column completely which contains 10 points (point size = 1 mm$^2$)

All laser beams coming from mirror 18 must be orthogonal to the vertical axis which is the rotating axis of mirror 19. The vertical rotating axis of mirror 20 must be parallel to mirror 19.

The mirror vertical size of mirror 20 is 11 mm. The mirror width must respect those conditions:

- be as small as possible to allow high speed of micro-galva dynamic; and
- must be able to scan all points in a matrix line and for all packets.

All these conditions must be satisfied respected and the distance between mirror 19, mirror 20 and the matrix 8 must be as small as possible.

To find an optimized size and position of the mirror 19, 20 and the matrix 8, simulations were done by using a CAD/CAM software package, e.g., Code V optical CAD/CAM Software from Optical Research Associates. The result of CAD/CAM optical simulations are respective positions of the mirrors 19, 20 and the matrix 8. The CAD/ CAM simulations give also angles values combination for the mirrors 19, 20. These angle values correspond to multiplexing angle values used in matrix recording and the size of points number in matrix recording ($10 \times 10$ points with at least 15 packets per point).

In an alternative form of the embodiment of the read device 14 of FIG. 6A, the mirrors 19, 20 associated with their galvanometers are replaced with micromirrors (MOEMS) of the type of those developed by the German company IMS. Microoptoelectromechanical systems (MOEMS) refers to systems that combine electrical and mechanical components, including optical components, into a physically small size. Such micromirrors consist of a plate cut in a silicon substrate on which a reflected film is deposited, typically a film of aluminum with a typical thickness of about fifty nanometers. This plate is suspended from two or four twisting points and is actuated by two or four drive electrodes, depending on whether it is desired to have a mirror which rotates in one or two directions. The angle of deflection is in theory unlimited, but in practice it is about 60°. Moreover, the space lying between the mirror (the plate) and the drive electrodes forms a variable capacitor. Thus, applying a voltage generates an electrostatic torque acting on the plate and causing it to rotate and/or oscillate. Given the particularly small size of these micromirrors on the one hand, but also their mode of operation on the other, it becomes possible to reduce the size of the read device 14 significantly and hence achieve a very high level of integration.

In FIGS. 7 and 8 is shown a second embodiment of the read and addressing system according to the present invention, the mirrors being replaced with acoustooptic devices. When acoustooptical crystals are subjected to stress, especially by means of a transducer usually consisting of a piezoelectric crystal, they modify the angle of diffraction of the light and, in general, of the electromagnetic wave which passes through them. In order to modify the value of the diffraction angle of the emerging beam, all that is therefore required is to modify the actuating frequency of the piezoelectric transducer. The read or addressing speed in the storage medium 8 can thus be considerably increased. An example of a set-up of the addressing system using such a principle is shown in FIGS 7 and 8.

Because of the relatively small angle of diffraction available at the exit of such an acoustooptic material 21, 22, a two-dimensionally blazed grating 23 is oriented so that the angle of incidence of the beam is such that the diffracted beam (of order 1 or -1, depending on the gratings used) exits the grating at an angle close to the grazing angle (the grazing angle being at 90° to the normal to the surface of the grating).

Thus, as shown in FIGS 7 and 8, the variations in orientation along OX and OY of the incident read beam 20 emanating from a low-power laser are obtained by subjecting this beam to two acoustooptic components 21, 22. After these components, the diffraction angle is increased by means of a blazed grating 23 and then reflected off a series of micromirrors 24 (FIG. 7) or, alternately, off an Microoptoelectromechanical systems MEOMS 25 (FIG. 8) so as to obtain the desired angle of incidence at the storage medium 8.

Consequently it may be understood that, by varying the vibration frequency of the piezoelectric crystal associated with the acoustooptic component(s), it becomes possible to modify, very rapidly, the desired orientation of the grating within the rows and columns of the data-carrying matrix 8. The limiting factor then becomes the MEOMS or the micromirrors which act on the angle of incidence of the read beam at the matrix 8.

In light of the foregoing, many advantages of the present invention may be appreciated. Firstly, and taking into account the storage material used on the one hand and the recording and addressing procedure on the other, it becomes possible to very significantly increase the amount of information that can be stored in packets within an entity of relatively small physical size.

This result can also be obtained by using low-power read or recording devices, allowing the system to be miniaturized, in formats broadly compatible with that of the recording and storage devices known hitherto, or may even be greatly reduced in size compared with the latter.

Finally, because of the components used and because of the particular choice of storage material, access to the stored information can be carried out rapidly, without the need for devices which are expensive or difficult to use.

Software for positioning the read beam

FIG. 6A shows the addressing/read apparatus 14 having dynamic devices, for example, the micro mirrors 17-20 shaping and directing the reference beam generated by the laser 15 at a precise position and angle onto one of a plurality of points 8a of the storage medium 8. FIG. 5B shows the control mechanism 100 used to position the beam. The computer 106 sends signals 104 to the actuators 102 to position the beam onto the storage medium 8. During the read phase, the actuators 102 are the micro mirrors 17-20 shaping and directing the reference beam 4.

In angular multiplexing, the read beam is positioned in order to access a data packet contained at a defined point (X,Y) in the storage medium at the corresponding addressing angle. A scan is then made to retrieve the entire series of points making up a horizontal line in the medium along the OX axis. This process is repeated by incrementing the OY axis to scan a new line along the OX axis.

The read procedure is similar to the write procedure, in that they both use the same principle of nodal points. Thus, an activator or a member for shaping the read laser beam is placed at each node 102 of the system 100. The reading procedure is carried out with a greater degree of tolerance than the recording procedure. However, the laser source used for reading does not need to be as powerful as the laser source used for recording. Consequently, it is possible to use a very compact laser source of the solid-state type for the read process.

Read beam 15a is directed and shaped by one or more transformation nodes 102 located in an optical path of the read beam 15a to one of a plurality of points defining a matrix 8 on the storage medium as determined by one or more initial storage conditions and one or more operating parameters.

The initial storage conditions include the size of the matrix, the number of points of the matrix, and the physical characteristics of the polypeptide material. The physical characteristics of the polypeptide material include a selection of constitutive molecules and results from a process for preparing the polypeptide material. In the selection of a molecular arrangement, there are hundreds of thousands of molecules to choose from. Proteins to some extent can be considered to be polymers and are structured like monomers associated to each other.

The process for preparing the polypeptide material determines a wavelength sensitivity of the polypeptide material and includes a coating method. The physical characteristics of the polypeptide material are determinable by a recording process. The recording process is defined by at least one of the following parameters: light wavelength, temperature, humidity, and the physical characteristics of a substrate of the polypeptide material. The physical characteristics of the polypeptide material further include a post exposure process. The post exposure process is defined by factors such as the physical characteristic of baths and physical parameters such as temperature and humidity. The operating parameters include the desired time needed to access the storage medium, the type of activators used, the level of miniaturization, and the level of resolution.

The incident read laser beam 15a is modulated by means of one or more transformation activators 102 lying in the optical path of the beam. The activators 102 consist of dynamic devices typically consisting of mirrors or micromirrors associated with a dynamic component. They may also consist of acoustooptic components associated with a diffraction grating, or else Kerr or Pockels cells. One of the major difficulties confronting the present invention is how to position the dynamic devices in space and, as a corollary, how to control their orientation.

For this purpose, both for positioning and for orienting, software 108 has been developed in relation to the present invention for integrating a certain number of these items of data, among which are the constraints in terms of the nature of the wavefront and the size of the point of impact of the read beam.

The results of the computations performed by this software thus make it possible to accurately determine the positions of each of the activators 102. The activators 102 are divided into groups: the stationary components, consisting especially of the lenses, the parabolic mirror, the CCD camera for receiving the information read out and the laser source; and the moving components, and especially the mirrors or equivalent members.

According to one fundamental characteristic of the present invention, taking into account the material used, the tolerance necessary in terms of excitation or modulation of the read wavefront is relatively large. Thus, it becomes possible to use, as devices for activating the wavefront, systems already known for doing such and capable of achieving, at high speed, the desired modulation of the read beam wavefront and, as a corollary, of retrieving the desired data packet. For example, when the recording results from angular multiplexing, the angle of incidence of the read beam on the information medium at the point of defined coordinates (X,Y) may vary by a value within about one tenth of a degree, something which hitherto was not possible with storage and storage materials. This great iolerance means that the speed of access to the coded and stored information can be very significantly increased.

FIGS. 11 and 12 give an example of the retrieval of the information coming from the software processing for the following initial conditions:

semiconductor read laser (wavelength: 532 nm; beam size: 1.5 mm in diameter);

square matrix of 10 × 10 points (two consecutive points are separated by 1 mm along X and along Y); each point consists of 15 packets (or packets) 1 mm$^2$ in area; the first packet is recorded at a multiplexing angle of 10°; the fifteenth packet is recorded at a multiplexing angle of 38°; and the spacing between two consecutive multiplexing angles is 2°.

FIG. 10 shows the calculation of the rectilinear coordinates (XDE, YDE, ZDE) and the angle (ADE, BDE, CDE) of the read beam for the point at X = 1mm and n = 1°. FIG. 11 shows the calculation of values for positioning the components for different degree values.

Calculation positions of transformation nodes

In FIG. 6A is shown an apparatus 14 comprising a read beam 15a directed and shaped by one or more transformation nodes 1-6 located in an optical path of said read beam 15a to one of a plurality of points 8a, 8b defining a matrix on the storage medium 8 as determined by one or more initial storage conditions and one or more operating parameters.

An example is now given for the case where the transformation nodes 1-6 are the nodes of the read apparatus of FIG. 6A. in FIG. 6A, the transformation nodes 1-6 are represented in a program as variables OBJ, STO, NODE5, NODE6, and IMG. Node OBJ represents the position within the reading apparatus 14 occupied by the memory matrix 8. STO is a virtual point located between the matrix 8 and the mirror 20. STO corresponds to a stop for adjusting the size of the cross section of the read laser beam to the size of the point to be read off of the matrix 8. This stop is virtually located between Node OBJ positioned at the mirror 20 and Node 6 positioned at the matrix 8. Node 6 corresponds to the node where the mirror 20, mounted on a galvanometer, is located. Node 5 corresponds to the node where a second mirror 19 is mounted on another galvanometer. The IMG node corresponds to the node for image formation. An optical CAD software is based on the strict tracing of light rays coming from an object field as far as the image formation plane. Lying between these two extremities are the various types of surfaces (reflective and refractive) through which the light beam has to pass. In this example, this node being the IMG node corresponds to mirror 18, that is, the node where the concave mirror for shaping the laser beam is located.

The simulation of the optimized positions for the transformation nodes (OBJ, STO, NODE5, NODE6, IMG) is entirely defined by the computed values of the spatial and angular coordinates. The spatial coordinates for a point on the (x, y, z) axis is defined in the computer program by the variables: XDE , YDE, and ZDE. A unique angular coordinate for a spatial point is given by the variables ADE, BDE and CDE. FIG. 11 shows an example of a computer printout of the spatial and angular coordinates for a point at 1mm and an angle of 10 degrees. FIG. 12 shows the calculation of values for positioning the components for different degree values.

According to the particular embodiment of the invention, the angular variation of the reference beam with respect to the normal to the plane formed by the storage material varies in steps of 2° between two extreme values lying between 10° and 38°. Thus, 15 angular directions corresponding to 15 possible ways of storing different images for a given (X,Y) position are used.

The energy used to store the information, and especially the energy needed for the reduction reaction affecting the chromium VI ions contained in the constitutive material, is relatively low and typically about a few millijoules/cm$^2$. For such an energy, the write or recording time is also relatively short, typically about 10 milliseconds.

According to the particular embodiment described, when the laser beam has undergone a discrete variation in steps of 2° between the two above-defined extreme values, the plate supporting the storage material according to the invention undergoes a translation of 1 mm until coming to the adjacent write or recording area. The recording operation is repeated for this new position. The reference laser beam undergoes a new discrete variation in steps of 2° corresponding each time to writing a new packet into the storage material. At the end of an entire line in the material, the latter resumes its initial position by a suitable support plate system and, as a corollary, undergoes a height translation along OY in order to start the process of recording the next line along OX, and so on.

Flow chart for read phase

As shown in FIG. 12, at step 210 the read phase begins by adjusting the power of the laser beam. Parameters of the laser such as power, stability, coherence (spatial or temporal) are adjusted. The term "adjust laser" means that the laser technology is selected so that its power, polarization, wavelength mode structure, mode stability and size format of the laser fits the global design of the system.

At step 215, the beam is then configured to read the information from the matrix 8 at a given multiplexing angle. The optics is adjusted so that the beam has a 1 mm size. The term "Laser beam reshape" means that the laser beam size fits as exactly as possible the size of one point. The laser beam intensity has to be as uniform as possible around a Gaussian profile.

At step 220, the address system is arranged as a group of activators that are spatially organized to directionally process the beam in such a way that a targeted point will be reached by the laser beam at a specific angle and with a satisfying geometrical accuracy.

At step 225, the dimensions of the address system are determined in order to minimize its size. For example, the size of the system could be medium using galva mirrors or small using MEOMS. The dimensions of the address system depends on the size of the directional beam processor. With MEOMS it will be miniaturized but it will be "laboratory size" with motor activated mirrors.

At step 230, the read beam is then directed to the storage medium 8 at a precise point and angle wherein it interacts with the matrix 8 to retrieve the information at that point and angle. After the processing steps the laser beam is going to hit the selected point in the XY plane with a selected angle at a given time.

At step 235 is concerned with the extraction of the signal content is extracted from the matrix memory.

At step 240, the storage medium is used in various applications, for example defense 241, networks 242, consumer products 243, and computers 244. The digital data will be packaged differently according to the targeted applications.

**Claims**

1. A photonics memory, comprising:

   a polypeptide storage material sensitive to a spatial distribution of light energy produced by interference of a coherent reference light beam and a coherent object light beam for recording said spatial distribution of light energy, **characterized in that** said polypeptide material comprises a solution of chromium-doped collagen.

2. The photonics memory of claim 1, wherein in said solution of chromium-doped collagen $\alpha$ and $\beta$ chains are predominantly present in proportions such that an $\alpha/\beta$ ratio is greater than 1.

3. The photonics memory of claim 2, wherein said $\alpha/\beta$ ratio is between about 1.2 and about 2.1.

4. The photonics memory of claim 2, wherein said chromium doping is carried out by adding a chromium VI salt to said polypeptide solution in an amount of 5 to 10% by weight of dry polypeptide.

5. The photonics memory of claim 2, wherein the average molecular weight of said polypeptide material is between 120 000 and 150 000 Daltons.

6. The photonics memory of claim 2, wherein the viscosity of said polypeptide solution is between about three and about four centipoise.

7. The photonics memory of claim 2, wherein said polypeptide solution is also doped with a hardening agent in an amount of about 0.5% by weight of dry polypeptide.

8. The photonics memory of claim 2, wherein said collagen solution is doped with a fluorinated surfactant.

9. A data storage system comprising the photonics memory of claim 1, wherein data is encoded in a recording medium by a holographic process wherein said medium is made up of a collagen based polypeptide material, said polypeptide material doped with a soluble chromium VI salt and the alpha and beta chains of said polypeptide material are predominantly present in proportions such that the alpha/beta chain weight ratio is greater than 1.

10. The storage system of claim 9, wherein said polypeptide material is doped with said chromium VI salt in the amount of from about 5% to about 10% by weight of dry polypeptide.

11. The storage system of claim 9, wherein said alpha/beta chain weight ratio is between about 1.2 and about 2.1.

12. The storage system of claim 9, wherein said polypeptide material is a gel having a gelling strength between about 90 and about 300 bloom.

13. The storage system of claim 9, wherein the average molecular weight of said collagen based polypeptide material is between about 120,000 and about 150,000 Daltons.

14. The storage system of claim 9, wherein said polypeptide material is a gel having a viscosity between about three and about four centipoise as measured by the Standard Method.

15. The storage system of claim 9, wherein said polypeptide material includes a polypeptide hardening agent in an amount of about 0.5% by weight of dry polypeptide.

16. The storage system of claim 15, wherein said hardening agent comprises a water-soluble chromium III salt.

17. The storage system of claim 15, wherein said hardening agent comprises aluminium sulfate.

18. The storage system of claim 9, wherein said polypeptide material includes a surfactant.

19. The storage system of claim 9, wherein said polypeptide material includes a surfactant of the fluorocarbon type.

20. The storage system of claim 9, wherein said polypeptide material is a gel having a gelling power of about 250 bloom.

21. The storage system of claim 9, wherein the average molecular weight of said polypeptide material is about 120,000 Daltons.

22. The storage system of claim 9, wherein said polypeptide material is a gel having a viscosity of about 3.5 centipoise as measured by the Standard Method.

23. The storage system of claim 9, wherein said polypeptide material is deposited as relatively uniform layer on a clear transparent substrate.

24. The storage system of claim 23, wherein an adhesive layer is formed between said recording medium layer and the surface of said clear transparent substrate so as to bond said recording medium to said clear transparent substrate.

25. The storage system of claim 23, wherein said clear transparent substrate is a glass plate.

26. The storage system of claim 23, wherein said clear transparent substrate is a plastic substrate.

27. The storage system of claim 26, wherein said plastic substrate is a plastic sheet.

28. The storage system of claim 26, wherein said plastic substrate is a plastic film.

29. The storage system of claim 9, wherein said recording medium layer is covered with a protective substrate.

30. The storage system of claim 29, wherein said protective substrate is a glass plate.

31. The storage system of claim 29, wherein said protective substrate is a plastic plate.

32. The storage system of claim 29, wherein said protective substrate is hydrophobic varnish coating.

33. A volume holographic memory comprising the photonics memory of claim 1 which comprises
a polypeptide recording material doped with a chromium VI salt sensitive to a spatial distribution of light energy produced by interference of a coherent reference light beam and a coherent object light beam for recording said spatial distribution of light energy, the alpha and beta chains of said polypeptide recording material are predominantly present in proportions such that the alpha/beta chains weight ratio is greater than 1.

34. The volume holographic memory of claim 33, wherein said polypeptide material is doped with said chromium VI salt in the amount of from about 5 to about 10% by weight of the dry polypeptide.

35. The volume holographic memory of claim 33, wherein said polypeptide recording material comprising a collagen based polypeptide gel in which the viscosity of said gel is between about 3 and about 4 centipoise as measured by the Standard Method.

36. The volume holographic memory of claim 33, wherein said alpha/beta chains ratio weight is between about 1.2 and about 2.1.

37. The volume holographic memory of claim 33, wherein said polypeptide recording material has a loading of about 10% by weight chromium VI.

38. The volume holographic memory of claim 33, wherein the average molecular weight of said collagen based polypeptide is between about 120,000 and about 150,000 Daltons.

39. The volume holographic memory of claim 33, wherein said polypeptide recording medium is a gel having a gelling strength between about 90 and about 300 bloom.

40. The volume holographic memory of claim 33, wherein said chromium VI doped polypeptide material includes a polypeptide hardening agent.

41. The volume holographic memory of claim 40, wherein said hardening agent comprises a chromium III salt.

42. The volume holographic memory of claim 40, wherein said hardening agent comprises aluminium sulfate.

43. The volume holographic memory of claim 33, wherein said chromium VI doped polypeptide material includes a surfactant.

44. The volume holographic memory of claim 33, wherein said polypeptide material includes a surfactant of the fluorocarbon type.

45. The volume holographic memory of claim 33, wherein said polypeptide material is a gel having a gelling power of about 250 bloom.

46. The volume holographic memory of claim 33, wherein the average molecular weight of said polypeptide material is about 120,000 Daltons.

47. The volume holographic memory of claim 33, wherein said polypeptide material is a gel having a viscosity of about 3.5 centipoise as measured by the Standard Method.

48. The volume holographic memory of claim 33, wherein said polypeptide material is deposited as relatively uniform layer on a clear transparent substrate.

49. The volume holographic memory of claim 48, wherein an adhesive layer is formed between said recording medium layer and the surface of said clear transparent substrate so as to bond said recording medium to said clear transparent substrate.

50. The volume holographic memory of claim 48, wherein said clear transparent substrate is a glass plate.

51. The volume holographic memory of claim 48, wherein said clear transparent substrate is a plastic substrate.

52. The volume holographic memory of claim 51, wherein said plastic substrate is a plastic sheet.

53. The volume holographic memory of claim 51, wherein said plastic substrate is a plastic film.

54. The volume holographic memory of claim 33, wherein said recording medium is covered with a protective substrate.

55. The volume holographic memory of claim 54, wherein said protective substrate is a glass plate.

56. The volume holographic memory of claim 54, wherein said protective substrate is a plastic plate.

57. The volume holographic memory of claim 54, wherein said protective substrate is hydrophobic varnish coating.

58. The volume holographic memory of claim 40, wherein said hardening agent is Cr III.

59. A method for producing a data storage medium having the photonics memory of claim 1 comprising a polypeptide gel coating on a substrate comprising:

swelling a polypeptide of biological origin in water at room temperature to form a polypeptide solution, the alpha and beta chains of said polypeptide are predominately present in portions such that the alpha/beta chain weight ratio is greater than 1;
heating said polypeptide solution to a temperature between about 40 and about 60°C until said polypeptide has completely dissolved;
incorporating soluble chromium VI salt in the amount of about 5 to about 10% by weight of dried polypeptide into said polypeptide solution to dope said polypeptide;
filtering said doped polypeptide solution;
maintaining said doped polypeptide solution between about 55 and about 60°C for a period between 15 to 60 minutes;
depositing said doped polypeptide solution thus obtained as a coating on a substrate;
chilling said deposited doped polypeptide coating to solidify same; and
drying said deposited doped polypeptide coating to obtain a data storage medium comprising a polypeptide gel coating on said substrate.

60. The method of claim 59, wherein said substrate is a glass plate and said doped polypeptide solution is deposited on said glass plate by gravitational coating.

61. The method of claim 59, wherein said substrate is a plastic substrate and said doped polypeptide solution is deposited on said plastic substrate.

62. The method of claim 59, wherein said substrate is a plastic substrate and said doped polypeptide solution is deposited on said plastic substrate by Doctor blade extruding or Meyer bar extruding.

63. The method of claim 59, wherein a thin hydrophilic adhesive layer is sandwiched between said substrate and said doped polypeptide coating.

64. The method of claim 59, wherein a surfactant of the fluorocarbon type is incorporated into said polypeptide solution prior to incorporating a chromium VI ion into said polypeptide solution.

65. The method of claim 59, wherein a polypeptide hardening agent is incorporated into said doped polypeptide prior to filtering said doped polypeptide solution.

66. The method of claim 59, wherein said polypeptide gel has a gelling power between about 90 and about 300 bloom.

67. The method of claim 59, wherein said polypeptide gel has a viscosity between about 3 and about 4 centipoises.

68. The method of claim 59, wherein said polypeptide of biological origin has an average molecular weight between about 120,000 and about 150,000 Daltons.

69. The method of claim 59, wherein said alpha/beta chains weight ratio is between about 1.2 and about 2.1.

70. The method of claim 59, wherein said polypeptide gel has a gelling power of about 250 bloom.

71. The method of claim 59, wherein the average molecular weight of said polypeptide of biological origin is about 120,000 Daltons.

72. The method of claim 59, wherein said polypeptide gel has a viscosity of about 3.5 centipoise as measured by the Standard Method.

73. The method of claim 61, wherein the plastic substrate is a plastic sheet.

74. The method of claim 61, wherein said plastic substrate is a plastic film.

75. A method for producing a data storage medium having the photonics memory of claim 1 comprising a polypeptide gel coating on a plate comprising:

swelling a polypeptide of biological origin in water at room temperature to form a polypeptide solution, the alpha and beta chains of said polypeptide are predominately present in portions such that the alpha/beta chain weight ratio is greater than 1;
heating said polypeptide solution to a temperature between about 40 and about 60°C until said polypeptide has completely dissolved;
incorporating soluble chromium VI salt in the amount of about 5 to about 10% by weight of dried polypeptide into said polypeptide solution to dope said polypeptide;
filtering said doped polypeptide solution;
maintaining said doped polypeptide solution between about 55 and about 60°C for a period between 15 to 60 minutes;
depositing said doped polypeptide solution thus obtained between two spaced apart facing plates to fill the space between said facing plates, the inner surface of said first facing plate being coated with a hydrophobic film to prevent bonding of said polypeptide solution to said inner surface;
chilling said deposited doped polypeptide coating to solidify same;
removing said first plate leaving said other plate with chilled doped polypeptide coating deposited thereon; and
drying said deposited doped polypeptide coating to obtain a data storage medium comprising a polypeptide gel coating on said other plate.

76. The method according to claim 75, wherein said other plate is a glass plate.

77. The method according to claim 75, wherein said other plate is a plastic plate.

78. An apparatus for recording digital information in the photonics memory of claim 1, comprising:

an object light beam carrying said digital information ;
a reference light beam ; and
a storage medium made up of polypeptide material, in which said reference light beam and said object light beam intersect to form an interference pattern which is stored throughout the entire thickness of said storage medium, wherein said polypeptide material comprising a solution of chromium-doped collagen.

79. The apparatus of claim 78, wherein said storage medium forms a volume phase grating in which said interference pattern is formed as a diffraction pattern.

80. The apparatus of claim 78, wherein said polypeptide material is in the form of a flat sheet defined by rectangular coordinates (X,Y) of a plane of said flat sheet and a packet of digital information modulated onto said object light beam is encoded as a sub diffraction pattern at a point of said plane.

81. The apparatus of claim 78, wherein the variation of the angular direction of said reference light beam is accomplished by variable spacing of from one to four degrees.

82. The apparatus of claim 78, wherein said storage medium is shaped in the form of a flat sheet defined by rectangular coordinates (X,Y) of a plane of said flat sheet, at least fifteen discrete variations being made in an angular direction of said reference light beam for coding a wavefront of said object light.

83. The apparatus of claim 78, wherein in said solution of chromium-doped collagen, $\alpha$ and $\beta$ chains are predominantly present in proportions such that an $\alpha/\beta$ ratio is greater than 1.

84. The apparatus of claim 78, wherein said $\alpha/\beta$ ratio is between about 1.2 and about 2.1.

85. The apparatus of claim 78, wherein said chromium doping is carried out by adding a chromium VI salt to said polypeptide solution in an amount of 5 to 10% by weight of dry polypeptide

86. An apparatus for reading stored digital information in the photonics memory of claim 1, comprising:

a storage medium made up of a polypeptide material having stored therein digital information as a plurality of packets stored throughout the entire thickness of said storage medium, wherein said polypeptide material comprises a solution of chromium-doped collagen ; and
a read light beam configured to address at least one of said packets in said storage medium.

87. The apparatus of claim 86, wherein said read beam is directed and shaped by one or more transformation nodes located in an optical path of said read beam to one of a plurality of points defining a matrix on said storage medium as determined by one or more initial storage conditions and one or more operating parameters.

88. The apparatus of claim 87, wherein one of said initial storage conditions is the size of said matrix.

89. The apparatus of claim 87, wherein one of said initial storage conditions is the number of said points in said matrix.

90. The apparatus of claim 87, wherein one of said initial storage conditions is physical characteristics of said polypeptide material.

91. The apparatus of claim 90, wherein said physical characteristics of said polypeptide material includes a selection of constitutive molecules.

92. The apparatus of claim 90, wherein said physical characteristics of said polypeptide material results from a process for preparing said polypeptide material.

93. The apparatus of claim 92, wherein said process for preparing said polypeptide material determines a wavelength sensitivity of said polypeptide material.

94. The apparatus of claim 92, wherein said process for preparing said polypeptide material includes a coating method.

95. The apparatus of claim 90, wherein said physical characteristics of said polypeptide material is determined by a recording process.

96. The apparatus of claim 95, wherein said recording process is defined by at least one of the following parameters: wavelength, temperature, humidity, and said physical characteristics of a substrate of said polypeptide material

97. The apparatus of claim 90, wherein said physical characteristics of said polypeptide material includes a post exposure process.

98. The apparatus of claim 97, wherein said post exposure process is defined by factors such as the physical characteristic of baths and physical parameters such as temperature and humidity.

99. The apparatus of claim 87, wherein said operating parameters includes the desired time needed to access said storage medium.

100. The apparatus of claim 87, wherein said operating parameters include the type of activators used.

101. The apparatus of claim 87, wherein said operating parameters include the level of miniaturization.

102. The apparatus of claim 87, wherein said operating parameters include the level of resolution.

103. The apparatus of claim 87, wherein said nodes consist of dynamic devices.

104. The apparatus of claim 103, wherein said dynamic devices are selected from a group comprising mirrors, micromirrors associated with a rotating component, acoustooptic components, diffraction gratings associated with liquid crystals, Kerr cells and Pockels cells.

105. The apparatus of claim 103, wherein the positioning in space of said dynamic devices and the control of their orientation are managed by software.

106. The apparatus of claim 87, wherein components positioned at said nodes for deflecting said read beam, comprise:

two acoustooptic devices which diffract, in a known manner, said read beam in an angular direction according to the frequency of ultrasonic waves applied;

a diffraction grating located downstream with respect to said acoustooptic devices and oriented in such a way that a beam emerging from said acoustooptic devices strikes the active face of said grating at a first angle being optimized so that a diffracted beam emerges at a second grazing angle; and

at least one dynamic angular deflection device located downstream with respect to said grating directing said beam emerging from said grating onto said storage medium

107. The apparatus of claim 86, wherein in said solution of chromium-doped collagen, $\alpha$ and $\beta$ chains are predominantly present in proportions such that an $\alpha/\beta$ ratio is greater than 1.

108. The apparatus of claim 107, wherein said $\alpha/\beta$ ratio is between about 1.2 and about 2.1.

109. The apparatus of claim 107, wherein said chromium doping is carried out by adding a chromium VI salt to said polypeptide solution in an amount of 5 to 10% by weight of dry polypeptide

**Patentansprüche**

1. Photonischer Speicher, umfassend:

   ein gegenüber einer räumlichen Verteilung von Lichtenergie empfindliches Polypeptidspeichermaterial, wobei die räumliche Verteilung von Lichtenergie durch Interferenz eines kohärenten Referenzlichtstrahls und eines kohärenten Objektlichtstrahls zur Aufzeichnung der räumlichen Verteilung von Lichtenergie erzeugt wurde, **dadurch gekennzeichnet, daß** das Polypeptidmaterial eine Lösung von chromdotiertem Collagen umfaßt.

2. Photonischer Speicher nach Anspruch 1, wobei in der Lösung des chromdotierten Collagens $\alpha$- und $\beta$- Ketten vorwiegend in solchen Anteilen vorliegen, daß ein $\alpha/\beta$- Verhältnis größer als 1 ist.

3. Photonischer Speicher nach Anspruch 2, wobei das $\alpha/\beta$-Verhältnis zwischen ungefähr 1,2 und ungefähr 2,1 ist.

4. Photonischer Speicher nach Anspruch 2, wobei die Chromdotierung durch Zugabe eines Chrom VI Salzes zu der Polypeptidlösung in einer Menge von 5 bis 10 Gew.-% des trockenen Polypeptids ausgeführt wird.

5. Photonischer Speicher nach Anspruch 2, wobei das mittlere Molekulargewicht des Polypeptidmaterials zwischen 120000 und 150000 Dalton ist.

6. Photonischer Speicher nach Anspruch 2, wobei die Viskosität der Polypeptidlösung zwischen ungefähr drei und ungefähr vier Centipoise ist.

7. Photonischer Speicher nach Anspruch 2, wobei die Polypeptidlösung auch mit einem Härtungsagens in einer Menge von ungefähr 0,5 Gew.-% des trockenen Polypeptids dotiert ist.

8. Photonischer Speicher nach Anspruch 2, wobei die Collagenlösung mit einem fluorierten Tensid dotiert ist.

9. Speichersystem, umfassend den photonischen Speicher nach Anspruch 1, in dem Daten in einem Aufzeichnungsmedium durch ein holographisches Verfahren codiert werden, wobei das Medium aus auf Collagen basierendem Peptidmaterial hergestellt ist, das Polypeptidmaterial mit einem löslichen Chrom VI Salz dotiert ist und die Alpha- und Betaketten des Polypeptidmaterials vorwiegend in solchen Anteilen vorliegen, daß das alpha/beta Kettengewichtsverhältnis größer als 1 ist.

10. Speichersystem nach Anspruch 9, wobei das Polypeptidmaterial mit dem Chrom VI Salz in der Menge von ungefähr 5 Gew.-% bis ungefähr 10 Gew.-% des trockenen Polypeptids dotiert ist.

11. Speichersystem nach Anspruch 9, wobei das alpha/beta Kettengewichtsverhältnis zwischen ungefähr 1,2 und ungefähr 2,1 ist.

12. Speichersystem nach Anspruch 9, wobei das Polypeptidmaterial ein Gel mit einer Gelstärke zwischen ungefähr

**EP 1 417 681 B1**

90 und ungefähr 300 Bloom ist.

13. Speichersystem nach Anspruch 9, wobei das mittlere Molekulargewicht des auf Collagen basierenden Polypeptidmaterials zwischen ungefähr 120000 und ungefähr 150000 Dalton ist.

14. Speichersystem nach Anspruch 9, wobei das Polypeptidmaterial ein Gel ist, das eine Viskosität zwischen ungefähr drei und vier Centipoise besitzt, wie nach dem Standardverfahren gemessen.

15. Speichersystem nach Anspruch 9, wobei das Polypeptidmaterial ein Polypeptidhärtungsagens in einer Menge von ungefähr 0,5 Gew.-% des trockenen Polypeptids einschließt.

16. Speichersystem nach Anspruch 15, wobei das Härtungsagens ein wasserlösliches Chrom in Salz umfaßt.

17. Speichersystem nach Anspruch 15, wobei das Härtungsagens Aluminiumsulfat umfaßt.

18. Speichersystem nach Anspruch 9, wobei das Polypeptidmaterial ein Tensid einschließt.

19. Speichersystem nach Anspruch 9, wobei das Polypeptidmaterial ein Tensid vom Fluorkohlenstofftyp einschließt.

20. Speichersystem nach Anspruch 9, wobei das Polypeptidmaterial ein Gel mit einer Gelstärke von ungefähr 250 Bloom ist.

21. Speichersystem nach Anspruch 9, wobei das mittlere Molekulargewicht des Polypeptidmaterials ungefähr 120000 Dalton ist.

22. Speichersystem nach Anspruch 9, wobei das Polypeptidmaterial ein Gel mit einer Viskosität von ungefähr 3,5 Centipoise ist, wie nach dem Standardverfahren gemessen.

23. Speichersystem nach Anspruch 9, wobei das Polypeptidmaterial als relativ einheitliche Schicht auf einem klaren, transparenten Substrat abgeschieden ist.

24. Speichersystem nach Anspruch 23, wobei eine Haftschicht zwischen der Schicht des Aufzeichnungsmediums und der Oberfläche des klaren, transparenten Substrats ausgebildet ist, um so das Aufzeichnungsmedium an das klare, transparente Substrat zu binden.

25. Speichersystem nach Anspruch 23, wobei das klare, transparente Substrat eine Glasplatte ist.

26. Speichersystem nach Anspruch 23, wobei das klare, transparente Substrat ein Kunststoffsubstrat ist.

27. Speichersystem nach Anspruch 26, wobei das Kunststoffsubstrat eine Kunststofftafel ist.

28. Speichersystem nach Anspruch 26, wobei das Kunststoffsubstrat ein Kunststofffilm ist.

29. Speichersubstrat nach Anspruch 9, wobei die Schicht des Aufzeichnungsmediums mit einem Schutzsubstrat bedeckt ist.

30. Speichersystem nach Anspruch 29, wobei das Schutzsubstrat eine Glasplatte ist.

31. Speichersystem nach Anspruch 29, wobei das Schutzsubstrat eine Kunststoffplatte ist.

32. Speichersystem nach Anspruch 29, wobei das Schutzsubstrat eine hydrophobe Lackbeschichtung ist.

33. Volumenholographischer Speicher, umfassend den photonischen Speicher nach Anspruch 1, der umfaßt:

ein mit einem Chrom VI Salz dotiertes Polypeptid-Aufzeichnungsmaterial, das gegenüber einer räumlichen Verteilung von Lichtenergie, die durch Interferenz eines kohärenten Referenzlichtstrahls und eines kohärenten Objektlichtstrahls zum Aufzeichnen der räumlichen Verteilung der Lichtenergie erzeugt wird, empfindlich ist, wobei die Alpha- und Betaketten des Polypeptid-Aufzeichnungsmaterials vorwiegend in solchen Anteilen vorliegen, daß das alpha/beta Kettengewichtsverhältnis größer als 1 ist.

34. Volumenholographischer Speicher nach Anspruch 33, wobei das Polypeptidmaterial mit den Chrom VI Salz in einer Menge von ungefähr 5 bis ungefähr 10 Gew.-% des trockenen Polypeptids dotiert ist.

35. Volumgenholographischer Speicher nach Anspruch 33, wobei das Polypeptid-Aufzeichnungsmaterial ein auf Collagen basiertes Polypeptidgel umfaßt, bei dem die Viskosität des Gels zwischen ungefähr 3 und ungefähr 4 Centipoise liegt, wie nach dem Standardverfahren gemessen.

36. Volumenholographischer Speicher nach Anspruch 33, wobei das alpha/beta Kettengewichtsverhältnis zwischen ungefähr 1,2 und ungefähr 2,1 ist.

37. Volumenholographischer Speicher nach Anspruch 33, wobei das Polypeptid-Aufzeichnungsmaterial eine Beladung von ungefähr 10 Gew.-% Chrom VI aufweist.

38. Volumenholographischer Speicher nach Anspruch 33, wobei das mittlere Molekulargewicht des auf Collagen basierten Polypeptids zwischen ungefähr 120000 und 150000 Dalton ist.

39. Volumenholographischer Speicher nach Anspruch 33, wobei das Polypeptidaufzeichnungsmedium ein Gel mit einer Gelstärke zwischen ungefähr 90 und ungefähr 300 Bloom ist.

40. Volumenholographischer Speicher nach Anspruch 33, wobei das Chrom VI dotierte Polypeptidmaterial ein Polypeptidhärtungsagens einschließt.

41. Volumenholographischer Speicher nach Anspruch 40, wobei das Härtungsagens ein Chrom III Salz umfaßt.

42. Volumenholographischer Speicher nach Anspruch 40, wobei das Härtungsagens Aluminiumsulfat umfaßt.

43. Volumenholographischer Speicher nach Anspruch 33, wobei das Chrom VI dotierte Polypeptidmaterial ein Tensid umfaßt.

44. Volumenholographischer Speicher nach Anspruch 33, wobei das Polypeptidmaterial ein Tensid vom Fluorkohlenstofftyp einschließt.

45. Volumenholographischer Speicher nach Anspruch 33, wobei das Polypeptidmaterial ein Gel mit einer Gelkraft von ungefähr 250 Bloom ist.

46. Volumenholographischer Speicher nach Anspruch 33, wobei das mittlere Molekulargewicht des Polypeptidmaterials ungefähr 120000 Dalton ist.

47. Volumenholographischer Speicher nach Anspruch 33, wobei das Polypeptidmaterial ein Gel mit einer Viskosität von ungefähr 3,5 Centipoise ist, wie nach dem Standardverfahren gemessen.

48. Volumenholographischer Speicher nach Anspruch 33, wobei das Polypeptidmaterial als relativ einheitliche Schicht auf einem klaren, transparenten Substrat abgeschieden ist.

49. Volumenholographischer Speicher nach Anspruch 48, worin eine Haftschicht zwischen der Schicht des Aufzeichnungsmediums und der Oberfläche des klaren, transparenten Substrats ausgebildet ist, um so das Aufzeichnungsmedium an das klare, transparente Substrat zu binden.

50. Volumenholographischer Speicher nach Anspruch 48, wobei das klare, transparente Substrat eine Glasplatte ist.

51. Volumenholographischer Speicher nach Anspruch 48, wobei das klare, transparente Substrat ein Kunststoffsubstrat ist.

52. Volumenholographischer Speicher nach Anspruch 51, worin das Kunststoffsubstrat eine Kunststofftafel ist.

53. Volumenholographischer Speicher nach Anspruch 51, wobei das Kunststoffsubstrat ein Kunststofffilm ist.

54. Volumenholographischer Speicher nach Anspruch 33, wobei das Aufzeichnungsmedium mit einem Schutzsubstrat bedeckt ist.

55. Volumenholographischer Speicher nach Anspruch 54, wobei das Schutzsubstrat eine Glasplatte ist.

56. Volumenholographischer Speicher nach Anspruch 54, wobei das Schutzsubstrat eine Kunststoffplatte ist.

57. Volumenholographischer Speicher nach Anspruch 54, wobei das Schutzsubstrat eine hydrophobe Lackbeschichtung ist.

58. Volumenholographischer Speicher nach Anspruch 40, wobei das Härtungsagens Chrom III ist.

59. Verfahren zur Herstellung eines Datenspeichennediums mit dem photonischen Speicher nach Anspruch 1, eine Polypeptidgelbeschichtung auf einem Substrat umfassend, wobei das Verfahren folgende Schritte umfaßt:

Quellen eines Polypeptids biologischer Herkunft in Wasser bei Raumtemperatur zur Bildung einer Polypeptidlösung, wobei die Alpha- und Betaketten des Polypeptids vorwiegend in solchen Anteilen vorliegen, daß das alpha/beta Kettengewichtsverhältnis größer als 1 ist;

Erhitzen der Polypeptidlösung auf eine Temperatur zwischen ungefähr 40 und ungefähr 60°C, bis das Polypeptid vollständig gelöst ist;

Einbringen eines löslichen Chrom VI Salzes in der Menge von ungefähr 5 bis ungefähr 10 Gew.-% des trokkenen Polypeptids in die Polypeptidlösung zur Dotierung des Polypeptids;

Filtrieren der dotierten Polypeptidlösung;

Halten der dotierten Polypeptidlösung zwischen ungefähr 55 und ungefähr 60°C für einen Zeitraum zwischen 15 bis 60 Minuten;

Abscheiden der so erhaltenen Polypeptidlösung als Beschichtung auf einem Substrat;

Kühlen der abgeschiedenen, dotierten Polypeptidbeschichtung zur Verfestigung derselben; und

Trocknen der abgeschiedenen, dotierten Polypeptidbeschichtung, um ein Datenspeichermedium zu erhalten, das eine Polypeptidgelbeschichtung auf dem Substrat umfaßt.

60. Verfahren gemäß Anspruch 59, wobei das Substrat eine Glasplatte ist und die dotierte Polypeptidlösung auf der Glasplatte durch Gravitationsbeschichtung abgeschieden wird.

61. Verfahren gemäß Anspruch 59, wobei das Substrat ein Kunststoffsubstrat ist und die dotierte Polypeptidlösung auf dem Kunststoffsubstrat abgeschieden wird.

62. Verfahren gemäß Anspruch 59, wobei das Substrat ein Kunststoffsubstrat ist und die dotierte Polypeptidlösung auf dem Kunststoffsubstrat mittels Streichmesserextrudierung oder Meyer-Balken-Extruktion abgeschieden wird.

63. Verfahren gemäß Anspruch 59, wobei eine dünne, hydrophile Haftschicht im Sandwich zwischen dem Substrat und der dotierten Polypeptidschicht angeordnet ist.

64. Verfahren gemäß Anspruch 59, wobei ein Tensid vom Fluorkohlenstofftyp vor dem Einbringen eines Chrom VI Ions in die Polypeptidlösung in dieselbe eingebracht wird.

65. Verfahren gemäß Anspruch 59, wobei ein Polypeptidhärtungsagens vor dem Filtrieren der dotierten Polypeptidlösung in das dotierte Polypeptid eingebracht wird.

66. Verfahren gemäß Anspruch 59, wobei das Polypeptidgel eine Gelstärke zwischen ungefähr 90 und ungefähr 300 Bloom besitzt.

**67.** Verfahren gemäß Anspruch 59, wobei das Polypeptidgel eine Viskosität zwischen ungefähr 3 und ungefähr 4 Centipoise besitzt.

**68.** Verfahren gemäß Anspruch 59, wobei das Polypeptid biologischen Ursprungs ein mittleres Molekulargewicht zwischen ungefähr 120000 und 150000 Dalton besitzt.

**69.** Verfahren gemäß Anspruch 59, wobei das Alpha-Betakettengewichtsverhältnis zwischen ungefähr 1,2 und ungefähr 2,1 ist.

**70.** Verfahren gemäß Anspruch 59, wobei das Polypeptidgel eine Gelkraft von ungefähr 250 Bloom besitzt.

**71.** Verfahren gemäß Anspruch 59, wobei das mittlere Molekulargewicht des Polypeptids biologischen Ursprungs ungefähr 120000 Dalton beträgt.

**72.** Vefahren gemäß Anspruch 59, wobei das Polypeptidgel eine Viskosität von ungefähr 3,5 Centipoise besitzt, wie nach dem Standardverfahren gemessen.

**73.** Verfahren gemäß Anspruch 61, wobei das Kunststoffsubstrat eine Kunststofftafel ist.

**74.** Verfahren gemäß Anspruch 61, wobei das Kunststoffsubstrat ein Kunststofffilm ist.

**75.** Verfahren zur Herstellung eines Datenspeichermediums mit dem photonischen Speicher nach Anspruch 1, umfassend eine Polypeptidgelbeschichtung auf einer Platte, wobei das Verfahren folgende Schritte umfaßt:

Quellen eines Polypeptids biologischen Ursprungs in Wasser bei Raumtemperatur zur Bildung einer Polypeptidlösung, wobei die Alpha- und Betaketten des Polypeptids vorwiegend in solchen Anteilen vorliegen, daß das alpha/beta Kettengewichtsverhältnis größer als 1 ist;

Erwärmen der Polypeptidlösung auf eine Temperatur zwischen ungefähr 40 und ungefähr 60°C bis das Polypeptid vollständig aufgelöst ist;

Einbringen einer löslichen Chrom VI Salzlösung in der Menge von ungefähr 5 bis ungefähr 10 Gew.-% des trockenen Polypeptids in die Polypeptidlösung zur Dotierung des Polypeptids;

Filtrieren der dotierten Polypeptidlösung;

Halten der dotierten Polypeptidlösung zwischen ungefähr 55 und ungefähr 60°C für einen Zeitraum zwischen 15 bis 60 Minuten;

Abscheiden der so erhaltenen, dotierten Polypeptidlösung zwischen zwei voneinander beabstandeten Platten, um den Platz zwischen den einander zugewandten Platten zu füllen, wobei die innere Oberfläche der ersten zugewandten Platte mit einem hydrophoben Film beschichtet ist, um ein Binden der Polypeptidlösung an die innere Oberfläche zu vermeiden;

Kühlen der abgeschiedenen, dotierten Polypeptidbeschichtung zur Verfestigung derselben;

Entfernen der ersten Platte, wobei die andere Platte mit der darauf gekühlten, dotierten, abgeschiedenen Polypeptidbeschichtung zurückgelassen wird; und

Trocknen der abgeschiedenen, dotierten Polypeptidbeschichtung zum Erhalt eines Datenspeichermediums, das eine Polypeptidgelbeschichtung auf der anderen Platte umfaßt.

**76.** Verfahren gemäß Anspruch 75, wobei die andere Platte eine Glasplatte ist.

**77.** Verfahren gemäß Anspruch 75, wobei die andere Platte eine Kunststoffplatte ist.

**78.** Vorrichtung zum Aufzeichnen digitaler Information in den photonischen Speicher nach Anspruch 1, umfassend:

einen Objektlichtstrahl, der die digitale Information trägt;

einen Referenzlichtstrahl; und

ein aus einem Polypeptidmaterial hergestelltes Speichermedium, in dem der Referenzlichtstrahl und der Objektlichtstrahl sich zur Bildung eines Interferenzmusters schneiden, das über die gesamte Dicke des Speichermediums gespeichert wird, wobei das Polypeptidmaterial eine Lösung von chromdotierten Collagen umfasst.

79. Vorrichtung nach Anspruch 78, wobei das Speichermedium ein Volumenphasengitter bildet, in dem das Interferenzmuster als ein Diffractionsmuster gebildet wird.

80. Vorrichtung nach Anspruch 78, wobei das Polypeptidmaterial in der Form einer flachen Tafel vorliegt, die durch Rechtecke Koordinaten (X, Y) einer Ebene der flachen Tafel definiert ist und ein auf den Objektlichtstrahl moduliertes Paket digitaler information in einem Punkt der Ebene als Subdiffractionsmuster codiert ist.

81. Vorrichtung nach Anspruch 78, wobei die Variation der Winkelrichtung des Referenzlichtstrahls durch variable Beabstandung von einem bis vier Grad bewegt wird.

82. Vorrichtung nach Anspruch 78, wobei das Speichermedium in der Form einer flachen Tafel geformt ist, die durch rechtwinklige Koordinaten (X, Y) einer Ebene der flachen Tafel definiert ist, wobei wenigstens fünfzehn diskrete Variationen in Winkelrichtung des Referenzlichtstrahls zur Codierung einer Wellenfront des Objektlichts ausgeführt werden.

83. Vorrichtung nach Anspruch 78, wobei in der Lösung des chromdotierten Collagens Alpha- und Betaketten überwiegend in solchen Anteilen vorliegen, daß ein $\alpha/\beta$ Verhältnis größer als 1 ist.

84. Vorrichtung nach Anspruch 78, wobei das $\alpha/\beta$ Verhältnis zwischen ungefähr 1,2 und ungefähr 2,1 ist.

85. Vorrichtung nach Anspruch 78, wobei das Dotieren mit Chrom durch Zugeben eines Chrom VI Salzes zu der Lösung in einer Menge von ungefähr 5 bis 10 Gew.-% des trockenen Polypeptids durchgeführt wird.

86. Vorrichtung zum Lesen gespeicherter digitaler Information in dem photonischen Speicher nach Anspruch 1, umfassend:

ein aus einem Polypeptidmaterial hergestelltes Speichermedium mit darin gespeicherter digitaler Information als eine Vielzahl von Paketen, die über die gesamte Dicke des Speichermediums gespeichert sind, wobei das Polypeptidmaterial eine Lösung von chromdotiertem Collagen umfaßt; und

ein zum Adressieren von wenigstens einem der Pakete in dem Speichermedium konfigurierten Leselichtstrahl.

87. Vorrichtung nach Anspruch 86, wobei der Lesestrahl durch ein oder mehrere Transformationsknoten, die in einem optischen Weg zu einer einer Vielzahl von Punkten angeordnet sind, die eine Matrix auf dem Speichermedium definieren, wie von einem oder mehreren Anfangsspeicherbedingungen bestimmt und einem oder mehreren Betriebsbedingungen, gerichtet und geformt wird.

88. Vorrichtung nach Anspruch 87, wobei einer der anfänglichen Speicherbedingungen die Größe der Matrix ist.

89. Vorrichtung nach Anspruch 87, wobei einer der anfänglichen Speicherbedingungen die Anzahl der Punkte in der Matrix ist.

90. Vorrichtung nach Anspruch 87, wobei einer der anfänglichen Speicherbedingungen die physikalischen Merkmale des Polypeptidmaterials sind.

91. Vorrichtung nach Anspruch 90, wobei die physikalischen Merkmale des Polypeptidmaterials eine Auswahl der bildenden Moleküle einschließt.

92. Vorrichtung nach Anspruch 90, wobei die physikalischen Merkmale des Polypeptidmaterials aus einem Verfahren zur Herstellung des Polypeptidmaterials resultieren.

93. Vorrichtung nach Anspruch 92, wobei das Verfahren zur Herstellung des Polypeptidmaterials eine Wellenlängeempfindlichkeit des Polypeptidmaterials bestimmt.

94. Vorrichtung nach Anspruch 92, wobei das Verfahren zur Herstellung des Polypeptidmaterials ein Beschichtungsverfahren einschließt.

95. Vorrichtung nach Anspruch 90, wobei die physikalischen Merkmale des Polypeptidmaterials durch einen Aufzeichnungsprozess bestimmt sind.

96. Vorrichtung nach Anspruch 95, wobei der Aufzeichnungsprozess durch wenigstens einen der folgenden Parameter definiert ist: Wellenlänge, Temperatur, Feuchtigkeit und die physikalischen Merkmale eines Substrats aus dem Polypeptidmaterial.

97. Vorrichtung nach Anspruch 90, wobei die physikalischen Merkmale des Polypeptidmaterials einen Prozess nach der Belichtung einschließen.

98. Vorrichtung nach Anspruch 97, wobei der Prozess nach der Belichtung durch Faktoren definiert ist, wie physikalische Merkmale von Bädern und physikalische Parameter, wie Temperatur und Feuchtigkeit.

99. Vorrichtung nach Anspruch 87, wobei die Betriebsparameter die gewünschte Zeit einschließen, die zum Zugriff auf das Speichermedium erforderlich ist.

100. Vorrichtung nach Anspruch 87, wobei die Betriebsparameter den Typ der verwendeten Aktivatoren einschließt.

101. Vorrichtung nach Anspruch 87, wobei die Betriebsparameter den Grad der Miniaturisierung einschließen.

102. Vorrichtung nach Anspruch 87, wobei die Betriebsparameter den Grad der Auflösung einschließen.

103. Vorrichtung nach Anspruch 87, wobei die Knoten aus dynamischen Einrichtungen bestehen.

104. Vorrichtung nach Anspruch 103, wobei die dynamischen Einrichtungen aus einer Gruppe ausgewählt sind, die Spiegel, mit einem Rotationsbestandteil verbundene Mikrospiegel, akustooptische Bestandteile, mit Flüssigkristallen verbundene Diffracionsgitter, Kerrzellen und Pockelszellen umfassen.

105. Vorrichtung nach Anspruch 103, wobei die räumliche Positionierung der dynmaischen Einrichtungen und die Steuerung ihrer Orientierung durch Software erfolgt.

106. Vorrichtung nach Anspruch 87, wobei die an den Knoten zur Ablenkung des Lesestrahls angeordneten Bestandteile umfassen:

zwei akustooptische Einrichtungen, die den Lesestrahl auf bekannte Weise in Winkelrichtung gemäß der Frequenz von einwirkenden Ultraschallwellen beugen;

ein stromab in Bezug auf die akustooptischen Einrichtungen angeordnetes und auf solche Weise orientiertes Diffractionsgitter, das ein aus den akustooptischen Einrichtungen austretender Strahl die aktive Fläche des Gitters in einem ersten Winkel trifft, der so optimiert ist, daß ein gebrochener Strahl in einem zweiten Glanzwinkel austritt; und

wenigstens eine dynamische Winkelablenkungseinrichtung, die in Bezug auf das Gitter stromab angeordnet ist und den aus dem Gitter austretenden Strahl auf das Speichermedium richtet.

107. Einrichtung nach Anspruch 86, wobei in der Lösung des chromdotierten Collagens Alpha- und Betaketten vorwiegend in solchen Anteilen vorliegen, daß ein $\alpha/\beta$ Verhältnis größer als 1 ist.

108. Vorrichtung nach Anspruch 107, wobei das $\alpha/\beta$ Verhältnis zwischen ungefähr 1,2 und ungefähr 2,1 ist.

**109.** Vorrichtung nach Anspruch 107, wobei die Chromdotierung durch Zufügen eines Chrom VI Salzes zu der Polypeptidlösung in einer Menge von 5 bis 10 Gew.-% des trockenen Polypeptids durchgeführt wird.

**Revendications**

1. Une mémoire photonique, comprenant :

   un matériau de stockage polypeptidique sensible à une distribution spatiale de l'énergie lumineuse produite par l'interférence d'un faisceau lumineux de référence cohérent et d'un faisceau lumineux objet cohérent permettant d'enregistrer ladite distribution spatiale de l'énergie lumineuse, **caractérisé en ce que** ledit matériau polypeptidique comprend une solution de collagène dopée au chrome.

2. La mémoire photonique selon la revendication 1, dans laquelle dans ladite solution de collagène dopée au chrome, les chaînes $\alpha$ et $\beta$ sont présentes de manière prédominante dans des proportions telles qu'un rapport $\alpha$ /$\beta$ est supérieur à 1.

3. La mémoire photonique selon la revendication 2, dans laquelle ledit rapport $\alpha$ / $\beta$ se situe entre environ 1,2 et environ 2,1.

4. La mémoire photonique selon la revendication 2, dans laquelle ledit dopage au chrome est réalisé en ajoutant un sel de chrome VI à ladite solution de polypeptide en une quantité de 5 à 10 % en poids du polypeptide sec.

5. La mémoire photonique selon la revendication 2, dans laquelle le poids moléculaire moyen dudit matériau polypeptidique se situe entre 120000 et 150000 daltons.

6. La mémoire photonique selon la revendication 2, dans laquelle la viscosité de ladite solution de polypeptide se situe entre environ trois et environ quatre centipoises.

7. La mémoire photonique selon la revendication 2, dans laquelle ladite solution de polypeptide est également dopée avec un agent durcissant dans une quantité d'environ 0,5 % en poids du polypeptide sec.

8. La mémoire photonique selon la revendication 2, dans laquelle ladite solution de collagène est dopée avec un agent tensioactif fluoré.

9. Un système de stockage de données comprenant la mémoire photonique selon la revendication 1, dans lequel les données sont codées dans un support d'enregistrement par un processus holographique, dans lequel ledit support est constitué d'un matériau polypeptidique à base de collagène, ledit matériau polypeptidique est dopé avec un sel de chrome VI soluble et les chaînes alpha et bêta dudit matériau polypeptidique sont principalement présentes dans des proportions telles que la proportion pondérale des chaînes alpha / bêta est supérieure à 1.

10. Le système de stockage selon la revendication 9, dans lequel ledit matériau polypeptidique est dopé avec ledit sel de chrome VI en une quantité d'environ 5 % à environ 10 % en poids du polypeptide sec.

11. Le système de stockage selon la revendication 9, dans lequel ladite proportion pondérale des chaînes alpha / bêta se situe entre environ 1,2 et environ 2,1.

12. Le système de stockage selon la revendication 9, dans lequel ledit matériau polypeptidique est un gel ayant un pouvoir gélifiant situé entre environ 90 et environ 300 blooms.

13. Le système de stockage selon la revendication 9, dans lequel le poids moléculaire moyen dudit matériau polypeptidique à base de collagène se situe entre environ 120000 et environ 150000 daltons.

14. Le système de stockage selon la revendication 9, dans lequel ledit matériau polypeptidique est un gel ayant une viscosité située entre environ trois et environ quatre centipoises, mesuré par la Méthode Standard.

15. Le système de stockage selon la revendication 9, dans lequel ledit matériau polypeptidique comprend un agent durcissant de polypeptide en une quantité d'environ 0,5 % en poids du polypeptide sec.

**16.** Le système de stockage de la revendication 15, dans lequel ledit agent durcissant comprend un sel de chrome III hydrosoluble.

**17.** Le système de stockage de la revendication 15, dans lequel ledit agent durcissant comprend du sulfate d'aluminium.

**18.** Le système de stockage de la revendication 9, dans lequel ledit matériau polypeptidique comprend un agent tensioactif.

**19.** Le système de stockage de la revendication 9, dans lequel ledit matériau polypeptidique comprend un agent tensioactif de type fluorocarbure.

**20.** Le système de stockage de la revendication 9, dans lequel ledit matériau polypeptidique est un gel ayant un pouvoir gélifiant d'environ 250 blooms.

**21.** Le système de stockage de la revendication 9, dans lequel le poids moléculaire moyen dudit matériau polypeptidique est d'environ 120000 daltons.

**22.** Le système de stockage de la revendication 9, dans lequel ledit matériau polypeptidique est un gel ayant une viscosité d'environ 3,5 centipoises, ainsi que mesuré par la Méthode Standard.

**23.** Le système de stockage de la revendication 9, dans lequel ledit matériau polypeptidique est déposé sous la forme d'une couche relativement uniforme sur un substrat transparent clair.

**24.** Le système de stockage de la revendication 23, dans lequel une couche adhésive est formée entre ladite couche de support d'enregistrement et la surface dudit substrat transparent clair de manière à coller ledit support d'enregistrement au dit substrat transparent clair.

**25.** Le système de stockage de la revendication 23, dans lequel ledit substrat transparent clair est une plaque de verre.

**26.** Le système de stockage de la revendication 23, dans lequel ledit substrat transparent clair est un substrat en plastique.

**27.** Le système de stockage de la revendication 26, dans lequel ledit substrat en plastique est une feuille de plastique.

**28.** Le système de stockage de la revendication 26, dans lequel ledit substrat en plastique est un film plastique.

**29.** Le système de stockage de la revendication 9, dans lequel ladite couche de support d'enregistrement est recouverte d'un substrat protecteur.

**30.** Le système de stockage de la revendication 29, dans lequel ledit substrat protecteur est une plaque de verre.

**31.** Le système de stockage de la revendication 29, dans lequel ledit substrat protecteur est une plaque de plastique.

**32.** Le système de stockage de la revendication 29, dans lequel ledit substrat protecteur est un revêtement de vernis hydrophobe.

**33.** Une mémoire holographique de volume comprenant la mémoire photonique selon la revendication 1 qui comprend :

un matériau d'enregistrement polypeptidique dopé avec un sel de chrome VI sensible à une distribution spatiale de l'énergie lumineuse produite par l'interférence d'un faisceau lumineux de référence cohérent et d'un faisceau lumineux objet cohérent permettant d'enregistrer ladite distribution spatiale de l'énergie lumineuse, les chaînes alpha et bêta dudit matériau d'enregistrement polypeptidique sont présentes de manière prédominante dans des proportions telles que la proportion pondérale des chaînes $\alpha / \beta$ est supérieure à 1.

**34.** La mémoire holographique de volume selon la revendication 33, dans laquelle ledit matériau polypeptidique est dopé avec ledit sel de chrome VI en une quantité d'environ 5 à environ 10 % en poids du polypeptide sec.

**35.** La mémoire holographique de volume selon la revendication 33, dans laquelle ledit matériau d'enregistrement polypeptidique comprenant un gel polypeptidique à base de collagène dans lequel la viscosité dudit gel se situe entre environ 3 et environ 4 centipoises, mesurée par la Méthode Standard.

**36.** La mémoire holographique de volume selon la revendication 33, dans laquelle ladite proportion pondérale des chaînes alpha / bêta se situe entre environ 1,2 et environ 2,1.

**37.** La mémoire holographique de volume selon la revendication 33, dans laquelle ledit matériau d'enregistrement polypeptidique a une charge d'environ 10 % en poids de chrome VI.

**38.** La mémoire holographique de volume selon la revendication 33, dans laquelle le poids moléculaire moyen dudit polypeptide à base de collagène se situe entre environ 120000 et environ 150000 daltons.

**39.** La mémoire holographique de volume selon la revendication 33, dans laquelle ledit support d'enregistrement polypeptidique est un gel ayant un pouvoir gélifiant situé entre environ 90 et environ 300 blooms.

**40.** La mémoire holographique de volume selon la revendication 33, dans laquelle ledit matériau polypeptidique dopé au chrome VI comprend un agent durcissant de polypeptide.

**41.** La mémoire holographique de volume selon la revendication 40, dans laquelle ledit agent durcissant comprend un sel de chrome III.

**42.** La mémoire holographique de volume selon la revendication 40, dans laquelle ledit agent durcissant comprend du sulfate d'aluminium.

**43.** La mémoire holographique de volume selon la revendication 33, dans laquelle ledit matériau polypeptidique dopé au chrome VI comprend un agent tensioactif.

**44.** La mémoire holographique de volume selon la revendication 33, dans laquelle ledit matériau polypeptidique comprend un agent tensioactif du type fluorocarbure.

**45.** La mémoire holographique de volume selon la revendication 33, dans laquelle ledit matériau polypeptidique est un gel ayant un pouvoir gélifiant d'environ 250 blooms.

**46.** La mémoire holographique de volume selon la revendication 33, dans laquelle le poids moléculaire moyen dudit matériau polypeptidique est d'environ 120000 daltons.

**47.** La mémoire holographique de volume selon la revendication 33, dans laquelle ledit matériau polypeptidique est un gel ayant une viscosité d'environ 3,5 centipoises, mesurée par la Méthode Standard.

**48.** La mémoire holographique de volume selon la revendication 33, dans laquelle ledit matériau polypeptidique est déposé sous la forme d'une couche relativement uniforme sur un substrat transparent clair.

**49.** La mémoire holographique de volume selon la revendication 49, dans laquelle une couche adhésive est formée entre ladite couche de support d'enregistrement et la surface dudit substrat transparent clair afin de coller ledit support d'enregistrement au dit substrat transparent clair.

**50.** La mémoire holographique de volume selon la revendication 48, dans laquelle ledit substrat transparent clair est une plaque de verre.

**51.** La mémoire holographique de volume selon la revendication 48, dans laquelle ledit substrat transparent clair est un substrat en plastique.

**52.** La mémoire holographique de volume selon la revendication 51, dans lequel ledit substrat en plastique est une feuille de plastique.

**53.** La mémoire holographique de volume selon la revendication 51, dans lequel ledit substrat en plastique est un film plastique.

**54.** La mémoire holographique de volume selon la revendication 33, dans lequel ledit support d'enregistrement est recouvert d'un substrat protecteur.

**55.** La mémoire holographique de volume selon la revendication 54, dans lequel ledit substrat protecteur est une plaque de verre.

**56.** La mémoire holographique de volume selon la revendication 54, dans lequel ledit substrat protecteur est une plaque de plastique.

**57.** La mémoire holographique de volume selon la revendication 54, dans lequel ledit substrat protecteur est un revêtement de vernis hydrophobe.

**58.** La mémoire holographique de volume selon la revendication 40, dans laquelle ledit agent durcissant est Cr III.

**59.** Un procédé de production d'un support d'enregistrement de données ayant la mémoire photonique selon la revendication 1 comprenant un revêtement de gel polypeptidique sur un substrat comprenant :

le gonflement d'un polypeptide d'origine biologique dans de l'eau à température ambiante afin de former une solution de polypeptide, les chaînes alpha et bêta dudit polypeptide sont présentes de manière prédominante en des portions telles que la proportion pondérale des chaînes $\alpha$ / $\beta$ est supérieure à 1 ;
le chauffage de ladite solution de polypeptide à une température située entre environ 40 et environ 60 °C jusqu'à ce que ledit polypeptide se soit complètement dissous ;
l'incorporation de sel de chrome VI soluble en une quantité d'environ 5 à environ 10 % en poids du polypeptide séché dans ladite solution de polypeptide afin de doper ledit polypeptide ;
la filtration de ladite solution de polypeptide dopée ;
le maintien de ladite solution de polypeptide dopée entre environ 55 et environ 60 °C pendant une période située entre 15 et 60 minutes ;
le dépôt de ladite solution de polypeptide dopée ainsi obtenue en tant que revêtement sur un substrat ;
le refroidissement rapide dudit revêtement de polypeptide dopé déposé afin de solidifier celui-ci ; et
le séchage dudit revêtement de polypeptide dopé déposé afin d'obtenir un support d'enregistrement de données comprenant un revêtement de gel de polypeptide sur ledit substrat.

**60.** Le procédé selon la revendication 59, dans lequel ledit substrat est une plaque de verre et ladite solution de polypeptide dopée est déposée sur ladite plaque de verre par revêtement gravitationnel.

**61.** Le procédé selon la revendication 59, dans lequel ledit substrat est un substrat en plastique et ladite solution de polypeptide dopée est déposée sur ledit substrat en plastique.

**62.** Le procédé selon la revendication 59, dans lequel ledit substrat est un substrat en plastique et ladite solution de polypeptide dopée est déposée sur ledit substrat en plastique par extrusion à la lame docteur ou extrusion à l'applicateur à spirales.

**63.** Le procédé selon la revendication 59, dans lequel une couche adhésive hydrophile mince est prise en sandwich entre ledit substrat et ledit revêtement de polypeptide dopé.

**64.** Le procédé selon la revendication 59, dans lequel un agent tensioactif du type fluorocarbure est incorporé dans ladite solution de polypeptide avant l'incorporation d'un ion chrome VI dans ladite solution de polypeptide.

**65.** Le procédé selon la revendication 59, dans lequel un agent durcissant de polypeptide est incorporé dans ledit polypeptide dopé avant la filtration de ladite solution de polypeptide dopée.

**66.** Le procédé selon la revendication 59, dans lequel ledit gel polypeptidique a un pouvoir gélifiant situé entre environ 90 et environ 300 blooms.

**67.** Le procédé selon la revendication 59, dans lequel ledit gel polypeptidique a une viscosité située entre environ 3 et environ 4 centipoises.

**68.** Le procédé selon la revendication 59, dans lequel ledit polypeptide d'origine biologique a un poids moléculaire moyen situé entre environ 120000 et environ 150000 daltons.

69. Le procédé selon la revendication 59, dans lequel ladite proportion pondérale des chaînes alpha / bêta se situe entre environ 1,2 et environ 2,1.

70. Le procédé selon la revendication 59, dans lequel ledit gel polypeptidique a un pouvoir gélifiant d'environ 250 blooms.

71. Le procédé selon la revendication 59, dans lequel le poids moléculaire moyen dudit polypeptide d'origine biologique est d'environ 120000 daltons.

72. Le procédé selon la revendication 59, dans lequel ledit gel polypeptidique a une viscosité d'environ 3,5 centipoises, mesurée par la Méthode Standard.

73. Le procédé selon la revendication 61, dans lequel le substrat en plastique est une feuille de plastique.

74. Le procédé selon la revendication 61, dans lequel le substrat en plastique est un film plastique.

75. Un procédé de production d'un support d'enregistrement de données ayant la mémoire photonique selon la revendication 1 comprenant un revêtement de gel polypeptidique sur une plaque comprenant :

le gonflement d'un polypeptide d'origine biologique dans de l'eau à température ambiante afin de former une solution de polypeptide, les chaînes alpha et bêta dudit polypeptide sont présentes de manière prédominante dans des portions telles que la proportion pondérale des chaînes $\alpha$ / $\beta$ est supérieure à 1 ;
le chauffage de ladite solution de polypeptide à une température située entre environ 40 et environ 60 °C jusqu'à ce que ledit polypeptide se soit complètement dissous ;
l'incorporation de sel de chrome VI soluble à raison d'environ 5 à 10 % en poids du polypeptide séché dans ladite solution de polypeptide afin de doper ledit polypeptide ;
la filtration de ladite solution de polypeptide dopée ;
le maintien de ladite solution de polypeptide dopée entre environ 55 et environ 60 °C pendant une période située entre 15 et 60 minutes ;
le dépôt de ladite solution de polypeptide dopée ainsi obtenue entre deux plaques opposées à distance afin de remplir l'espace entre lesdites plaques opposées, la surface interne de ladite première plaque opposée étant revêtue d'un film hydrophobe afin d'empêcher la liaison de ladite solution de polypeptide à ladite surface interne ;
le refroidissement profond dudit revêtement de polypeptide dopé déposé afin de solidifier celui-ci ;
l'élimination de ladite première plaque, laissant ladite autre plaque avec le revêtement de polypeptide dopé refroidi déposé sur celle-ci ; et
le séchage dudit revêtement de polypeptide dopé déposé afin d'obtenir un support d'enregistrement de données comprenant un revêtement de gel de polypeptide sur ladite autre plaque.

76. Le procédé selon la revendication 75, dans lequel ladite autre plaque est une plaque de verre.

77. Le procédé selon la revendication 75, dans lequel ladite autre plaque est une plaque en plastique.

78. Un appareil pour l'enregistrement d'informations numériques dans la mémoire photonique selon la revendication 1, comprenant :

un faisceau lumineux objet portant lesdites informations numériques ;
un faisceau lumineux de référence ; et
un support de stockage constitué de matériau polypeptidique, dans lequel ledit faisceau lumineux de référence et ledit faisceau lumineux objet se croisent afin de former une image d'interférence qui est stockée dans toute l'épaisseur dudit support d'enregistrement, ledit matériau polypeptidique comprenant une solution de collagène dopé au chrome.

79. L'appareil selon la revendication 78, dans lequel ledit support de stockage forme un réseau de phase en volume dans lequel ladite image d'interférence est formée en tant qu'image de diffraction.

80. L'appareil selon la revendication 78, dans lequel ledit matériau polypeptidique se présente sous la forme d'une feuille plate définie par des coordonnées rectangulaires (X, Y) d'un plan de ladite feuille plate et un paquet d'informations numériques modulé sur ledit faisceau lumineux objet est codé à titre d'image de subdiffraction à un point dudit plan.

81. L'appareil selon la revendication 78, dans lequel la variation de la direction angulaire dudit faisceau lumineux de référence est réalisée par des paliers variables de un à quatre degrés.

82. L'appareil selon la revendication 78, dans lequel ledit support de stockage est mis sous forme d'une feuille plate définie par des coordonnées rectangulaires (X, Y) d'un plan de ladite feuille plate, au moins quinze variations discrètes étant réalisées dans une direction angulaire dudit faisceau lumineux de référence afin de coder un front d'onde de ladite lumière objet.

83. L'appareil selon la revendication 78, dans lequel dans ladite solution de collagène dopée au chrome, les chaînes $\alpha$ et $\beta$ sont présentes de manière prédominante dans des proportions telles qu'un rapport $\alpha / \beta$ est supérieur à 1.

84. L'appareil selon la revendication 78, dans lequel ledit rapport $\alpha / \beta$ se situe entre environ 1,2 et environ 2,1.

85. L'appareil selon la revendication 78, dans lequel ledit dopage au chrome est réalisé en ajoutant un sel de chrome VI à ladite solution de polypeptide en une quantité de 5 à 10 % en poids du polypeptide sec.

86. Un appareil permettant de lire des informations numériques stockées dans la mémoire photonique selon la revendication 1, comprenant :

   un support de stockage constitué d'un matériau polypeptidique ayant des informations numériques stockées dans celui-ci sous la forme d'une pluralité de paquets stockés dans toute l'épaisseur dudit support de stockage ; dans lequel ledit matériau polypeptidique comprenant une solution de collagène dopée au chrome ; et
   un faisceau lumineux de lecture configuré afin d'adresser au moins un desdits paquets dans ledit support de stockage.

87. L'appareil selon la revendication 86, dans lequel ledit faisceau de lecture est dirigé et conformé par un ou plusieurs noeuds de transformation situés dans un chemin optique dudit faisceau de lecture vers l'un parmi une pluralité de points définissant une matrice sur ledit support d'enregistrement, ainsi que déterminé par une ou plusieurs conditions de stockage initiales et un ou plusieurs paramètres de service.

88. L'appareil selon la revendication 87, dans lequel l'une desdites conditions de stockage initiales est la taille de ladite matrice.

89. L'appareil selon 1a revendication 87, dans lequel l'une desdites conditions de stockage initiales est le nombre de dits points dans ladite matrice.

90. L'appareil selon la revendication 87, dans lequel l'une desdites conditions de stockage initiales est représentée par les caractéristiques physiques dudit matériau polypeptidique.

91. L'appareil selon la revendication 90, dans lequel lesdites caractéristiques physique dudit matériau polypeptidique comprennent une sélection de molécules constitutives.

92. L'appareil selon la revendication 90, dans lequel lesdites caractéristiques physiques dudit matériau polypeptidique sont le résultat d'un procédé de préparation dudit matériau polypeptidique.

93. L'appareil selon la revendication 92, dans lequel ledit procédé de préparation dudit matériau polypeptidique détermine une sensibilité aux longueurs d'ondes dudit matériau polypeptidique.

94. L'appareil selon la revendication 92, dans lequel ledit procédé de préparation dudit matériau polypeptidique comprend un procédé de revêtement.

95. L'appareil selon la revendication 90, dans lequel lesdites caractéristiques physiques dudit matériau polypeptidique sont déterminées par un procédé d'enregistrement.

**96.** L'appareil selon la revendication 95, dans lequel ledit procédé d'enregistrement est défini par au moins l'un des paramètres suivants : longueur d'onde, température, humidité et lesdites caractéristiques physiques d'un substrat dudit matériau polypeptidique.

**97.** L'appareil selon la revendication 90, dans lequel lesdites caractéristiques physiques dudit matériau polypeptidique comprennent un procédé de post-exposition.

**98.** L'appareil selon la revendication 97, dans lequel ledit procédé de post-exposition est défini par des facteurs, tels que la caractéristique physique des bains et des paramètres physiques, tels que la température et l'humidité.

**99.** L'appareil selon la revendication 87, dans lequel lesdits paramètres de service comprennent le temps souhaité nécessaire afin d'accéder au support de stockage.

**100.** L'appareil selon la revendication 87, dans lequel lesdits paramètres de service comprennent le type d'activateurs utilisés.

**101.** L'appareil selon la revendication 87, dans lequel lesdits paramètres de service comprennent le niveau de miniaturisation.

**102.** L'appareil selon la revendication 87, dans lequel lesdits paramètres de service comprennent le niveau de résolution.

**103.** L'appareil selon la revendication 87, dans lequel lesdits noeuds consistent en dispositifs dynamiques.

**104.** L'appareil selon la revendication 103, dans lequel lesdits dispositifs dynamiques sont sélectionnés dans un groupe constitué de miroirs, de micromiroirs associés à un composant rotatif, de composants acousto-optiques, de réseaux de diffraction associés à des cristaux liquides, de cellules de Kerr et de cellules de Pockel.

**105.** L'appareil selon la revendication 103, dans lequel le positionnement dans l'espace desdits dispositifs dynamiques et le contrôle de leur orientation sont gérés par un logiciel.

**106.** L'appareil selon la revendication 87, dans lequel les composants positionnés au niveau desdits noeuds pour dévier ledit faisceau de lecture comprennent :

deux dispositifs acousto-optiques qui permettent la diffraction, d'une manière connue, dudit faisceau de lecture dans une direction angulaire selon la fréquence d'ondes ultrasonores appliquée ;
un réseau de diffraction situé en aval par rapport auxdits dispositifs acousto-optiques et orienté de telle manière qu'un faisceau émergeant desdits dispositifs acousto-optiques frappe la face active dudit réseau selon un premier angle avec une optimisation telle qu'un faisceau diffracté émerge selon un deuxième angle d'incidence ; et
au moins un dispositif de déviation angulaire dynamique situé en aval par rapport au dit réseau dirigeant ledit faisceau, émergeant dudit réseau, sur ledit support de stockage.

**107.** L'appareil selon la revendication 86, dans lequel dans ladite solution de collagène dopée au chrome, les chaînes $\alpha$ et $\beta$ sont présentes de manière prédominante dans des proportions telles qu'un rapport $\alpha / \beta$ est supérieur à 1.

**108.** L'appareil selon la revendication 107, dans lequel ledit rapport $\alpha / \beta$ se situe entre environ 1,2 et environ 2,1.

**109.** L'appareil selon la revendication 107, dans lequel ledit dopage au chrome est réalisé en ajoutant un sel de chrome VI à ladite solution de polypeptide en une quantité de 5 à 10 % en poids du polypeptide sec.

FIG.1

FIG.2

```
                    ┌──────────────────────────┐
                    │  INITIALIZATION OF THE GPIB │───51
                    │       INTERFACE            │
                    └──────────────────────────┘
                              │ A
                              ▼
                    ┌──────────────────────────┐
                    │  INITIAL POSITION OF MATRIX │──52
                    │  RECORDING PLATE IN THE     │
                    │        (x,y) PLANE          │
                    └──────────────────────────┘
                              │ B
                              ▼
                    ┌──────────────────┐
                    │  INITIAL ANGLE   │──53
                    └──────────────────┘
                              │ C
                              ▼
      ┌──────────────┐        ┌──────────────┐
      │    NEXT      │        │   SENDING    │──54
      │   ANGLE      │        │    IMAGE     │
      └──────────────┘        └──────────────┘
           │  57                    │ D
           │ F                      ▼
           │              ┌──────────────────┐
           │              │  MIN DELAY TIME  │──55
           │              │     (5sec)       │
           │              └──────────────────┘
           │                      │ E
           │                      ▼
           │              ┌──────────────────┐
           │              │    RECORDING     │──56
           │              └──────────────────┘        ┌──────────────────┐
           │                                   58──── │  THE MINIMUM     │
           └───────────────────────────────           │  NUMBER OF       │
                                                       │  ANGLES IS 15    │
                                                       └──────────────────┘
                              │ G
                              ▼
                    ┌──────────────────────────┐
          H         │  INCREMENTATION OF THE    │──59
                    │   POSITION (STEP=1 mm)    │
                    └──────────────────────────┘
```

FIG.3

FIG.4

FIG.5A

FIG.5B

FIG.6A

FIG.6B

FIG.6C

FIG.6D

FIG.6E

POINT 2
POINT 1
LASER BEAM

FIG.6F

POINT 1

FIG.6G

POINT 10

FIG.7

FIG.8

INCIDENT
BEAM I

HOLOGRAPHIC
GRATING

**FIG.9**

32

DIFFRACTED
BEAM D

36

31

PHOTODIODE

REFLECTED
BEAM R

35

34

33

TRANSMITTED
BEAM T

| ADJUST LASER | 210 |

| LASER BEAM RESHAPE TO READ
THE ANGULAR MULTIPLEXING MATRIX | 215 |

| ADDRESS SYSTEM | 220 |

| DIMENSION OF THIS
SYSTEM | 225 |

**FIG.12**

| INTERACTION OF THE ADDRESSED
LASER BEAM WITH POINT OF MATRIX | 230 |

| EXTRACTION OF THE SIGNAL CONTENT
IN MATRIX MEMORY | 235 |

240

APPLICATIONS

241

AUTOMATIC,
AEROSPACE,
DEFENCE...

242

NETWORK

243

CONSUMER
PRODUCT

244

COMPUTER

1.POINT n⁰=1 (X=1mm)

$\theta_1 = -10°$

```
STO:      INFINITY     28.000000
   XDE:      0.000000  YDE:   -5.000000   ZDE:    0.000000   DAR
   ADE:      0.000000  BDE:    0.000000   CDE:    0.000000
NODE  6   INFINITY    -28.000000  REFL
   XDE:      0.000000  YDE:   -4.000000   ZDE:  -15.000000   DAR
   ADE:      0.100889  BDE:    0.000000   CDE:    0.000000
NODE  5   INFINITY      5.000000  REFL
   XDE:      0.000000  YDE:  -10.000000   ZDE:    0.000000   DAR
   ADE:    -14.901092  BDE:    0.000000   CDE:    0.000000
IMG:      INFINITY     28.000000
   XDE:      0.000000  YDE:  -37.400000   ZDE:    0.000000   DAR
   ADE:      0.000000  BDE:    0.000000   CDE:    0.000000
   EFL          REDU       PIM          OAL       EN PUP    EX PUP
************************************     0.000000   0.000000   -26.000000

ACTIVE CONSTRAINTS - 2:     TARGET    VALUE      DIFF      COST
Y S3 F1 W1 G3 R1        = 3.98000E-01  3.98000E-01  -1.332E-15  -1.814E-07
N S4 F1 W1 G4 R1        = 7.66000E-01  7.66000E-01   0.000E+00   7.186E-02
INACTIVE CONSTRAINTS:       TARGET    VALUE      DIFF
EFL                    = 1.00000E+18  1.00000E+18  -1.280E+02
Y S4 F1 W1 G4 R1       = -1.93101E-01 1.76330E-01   3.694E-01
CYCLE NUMBER 2:
ERR. F. =       88349.07801279     (CHANGE=    0.00000002)
X 33302.88749564
Y 55046.19051715
```

FIG.10

EP 1 417 681 B1

POINT 1 (X= 1mm)

| ANGULAR DIRECTION IN DEGREES | ANGLE GALVA2 (NODE 6) | ANGLE GALVA1 (NODE 5) |
|---|---|---|
| 10 | 0.100 | −14.901 |
| 12 | −1.815 | −15.817 |
| 14 | −3.731 | −16.733 |
| 16 | −5.647 | −17.647 |
| 18 | −7.558 | −18.560 |
| 20 | −9.470 | −19.472 |
| 22 | −11.380 | −20.382 |
| 24 | −13.287 | −21.289 |
| 26 | −15.192 | −22.194 |
| 28 | −17.095 | −23.097 |
| 30 | −18.994 | −23.996 |
| 32 | −20.890 | −24.892 |
| 34 | −22.782 | −25.784 |
| 36 | −24.669 | −26.671 |
| 38 | −26.552 | −27.554 |

POINT 2 (X= 2mm)

| ANGULAR DIRECTION IN DEGREES | ANGLE GALVA2 | ANGLE GALVA1 |
|---|---|---|
| 10 | 2.132 | −12.869 |
| 12 | 0.217 | −13.784 |
| 14 | −1.697 | −14.698 |
| 16 | −3.610 | −15.612 |
| 18 | −5.523 | −16.525 |
| 20 | −7.435 | −17.437 |

## FIG.11

| CHAINS | | | · | | γ | β | α | | | | |
|---|---|---|---|---|---|---|---|---|---|---|---|
| MOLECULAR<br>WEIGHT | <2500000 | <2000000 | <1000000 | <540000 | <340000 | <230000 | <125000 | <70000 | <49000 | <35000 | <25000 |
| PERCENTAGE OF<br>THE MOLECULAR<br>WEIGHT | | | 0.72% | 4.34% | 6.88% | 17.23% | 23.81% | 15.70% | 13.90% | 9.36% | 8.07% |

FIG.13

EP 1 417 681 B1

PREPARATION OF RAW MATERIAL
TREATMENT : CRUSH AND SLICE
FAT EXTRACTION BY ORGANIC
SOLVENT

ACID PROCESS

LIMING PROCESS

TREATMENT DURING 24 HOURS IN
ACETATE BATH pH 4-5 OR DURING
SEVERAL HOURS IN SULFURIC ACID
(pH2) AT ROOM TEMPERATURE

TREATMENT 1-6 MONTHS IN
LIMING LIQUOR (pH 12) OR FOR
ACCELERATE TIME WITH SODIUM
HYDROXYDE (NaOH) AT ROOM

ELIMINATION AT WASHING BATH
EXTRACTION IN A ACQUEOUS
SOLVENT AT pH NEUTRAL OR ACID
AT TEMPERATURE 50-95° C

ELIMINATION AT WASHING BATH
EXTRACTION IN A ACQUEOUS
SOLVENT AT pH NEUTRAL OR ACID
AT TEMPERATURE 50-95° C

POLYPEPTIDE AT pH 8-9.5

POLYPEPTIDE AT pH 4-5

CLARIFICATION BY:
−FLOCULATION
−SEPARATORS
−FILTRATION

FIG.14

GELIFICATION AND EVAPORATION IN FILM OR GRANULES

POUR POLYPEPTIDE POWDER (5g) IN DISTILLED WATER (94.5ml)

LEAVE TO SWELL

PUT IT INTO A WATER BATH AND HEAT IT (55°–60°C)

POUR AMMONIUM DICHROMATE (0.5g)

STIRRING

ADD A WATER TO COMPENSATE WATER EVAPORATION

FILTER

THERMOSTAT IN WATER BATH TILL COATING

POUR THE SOLUTION ON A PLATE

COAT ON A WARM HORIZONTAL TABLE (30°C)

STAY ON A COLD TABLE (17°C)

PUT IN A ATMOSPHERIC CHAMBER TO DRY (10°)

PUT IN A REFRIGERATOR FOR STORAGE

EXPOSURE ($\lambda$=514.5nm: E=550–650mJ/cm2)

FIXER + HARDENER
WATER 2 TIMES
ALCOHOL 25%
ALCOHOL 50%
ALCOHOL 75%
ALCOHOL 100% 2 TIMES

DEVELOPMENT

BAKE

SEAL → UV CURING

FIG.15

ADD GELATIN (0.5g) TO DISTILLED WATER (100ml)

↓

SWELLING

↓

HEATING TO 40°C

↓

STIRRING

↓

ADD 1 ml OF THE 10% CHROMIUM ALUM SOLUTION

↓

THERMOSTAT AT 30°C

↓

DIP THE CLEAN PLATES IN THE SOLUTION

↓

PUT THE PLATES VERTICALLY TO DRY IN CLEAN CHAMBER

## FIG.16